# EUROPEAN PATENT SPECIFICATION

(11) **EP 3 982 133 B1**
(45) Date of publication and mention of the grant of the patent: **18.09.2024**
(21) Application number: 20201301.7
(22) Date of filing: 12.10.2020
(51) Int. Cl.: G01R 31/28

(54) **PROGRESS CONTROL OF MATERIAL REMOVAL FROM COMPONENT CARRIER STRUCTURE DURING QUALITY TEST**
FORTSCHRITTSKONTROLLE DES MATERIALABTRAGS EINER KOMPONENTENTRÄGERSTRUKTUR WÄHREND EINES QUALITÄTSTESTS
CONTRÔLE DE L'AVANCEMENT DE L'ENLÈVEMENT DE MATIÈRE D'UNE STRUCTURE DE SUPPORT DE COMPOSANT PENDANT UN TEST DE QUALITÉ

(43) Date of publication of application: 13.04.2022
(73) Proprietor: AT & S Austria Technologie & Systemtechnik Aktiengesellschaft, 8700 Leoben-Hinterberg (AT)
(72) Inventor: Schutting, Günter, 8605 Kapfenberg (AT); Gruber, Irene, 8793 Trofaiach (AT); Spitzer, Robert, 8680 Mürzzuschlag (AT); Schwaiger, Jürgen, 8621 Thörl (AT); Pacher, Gernot, 8750 Judenburg (AT); Titjung, Florian, 8605 Kapfenberg (AT)
(74) Representative: Dilg, Haeusler, Schindelmann Patentanwaltsgesellschaft mbH

(56) References cited:
- US-A- 4 592 138
- US-A- 4 648 212
- US-A- 4 858 479
- US-A- 5 006 295
- US-A1- 2015 212 114
- US-A1- 2020 319 230

## Description

The invention relates to an apparatus for and a method of processing a component carrier structure for a quality test, a computer-readable medium, and a program element.

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. At the same time, component carriers shall be mechanically robust and electrically reliable so as to be operable even under harsh conditions.

Preparing and testing cross-sections of component carriers, flat ground component carriers, and related physical bodies is conventionally carried out manually by engineers. This holds for different types of microsections such as cross-sections and flat sections. However, this involves a high effort and a limited precision in terms of quality testing and may be critical concerning tough requirements regarding throughput on an industrial scale.

The documents US4,648,212 and US4,858,479 disclose apparatus and methods for PCB testing.

It is an object of the invention to assess quality of a component carrier structure with high reliability, high throughput and reasonable effort.

In order to achieve the object defined above, an apparatus for and a method of processing a component carrier structure for a quality test, a computer-readable medium, and a program element according to the independent claims are provided.

According to the invention, an apparatus for processing a component carrier structure for a quality test is provided, wherein the apparatus comprises a material removal unit configured for removing material of the component carrier structure for exposing at least one test target in an interior of the component carrier structure to be subjected to the quality test, a progress measuring unit configured for measuring a progress of the removal of material of the component carrier structure, an analysis unit configured for analyzing whether the measured progress meets requirements of a predefined material removal objective, and a control unit configured for controlling, based on a result of the analysis, whether or not the sequence of removing material, measuring a progress thereof, and analyzing whether the measured progress meets the requirements of the predefined material removal objective has to be repeated. In particular, the control unit may iteratively repeat once or a plurality of times the sequence of removing material, measuring a progress thereof (i.e. of the removal of material), and analyzing whether the measured progress meets the requirements until the pre-defined material removal objective is achieved.

According to the invention, a method of processing a component carrier structure for a quality test is provided, wherein the method comprises removing material of the component carrier structure for exposing at least one test target in an interior of the component carrier structure to be subjected to the quality test, measuring a progress of the removal of material of the component carrier structure, analyzing whether the measured progress meets requirements of a predefined material removal objective, and controlling, based on a result of the analyzing, whether or not the sequence of removing material, measuring a progress thereof, and analyzing whether the measured progress meets the requirements of the predefined material removal objective has to be repeated. In particular, the method may comprise iteratively repeating once or a plurality of times the sequence of removing material, measuring a progress thereof, and analyzing whether the measured progress meets the requirements until the predefined material removal objective is achieved.

According to the invention, a program element (for instance a software routine, in source code or in executable code) is provided, which, when being executed by a processor (such as a microprocessor or a CPU), is adapted to cause an apparatus having the above mentioned features to execute the steps of a method having the above mentioned features.

According to the invention, a computer-readable medium (for instance a CD, a DVD, a USB stick, an SD card, a floppy disk or a hard disk, or any other (in particular also smaller) storage medium) is provided, in which a computer program is stored which, when being executed by a processor (such as a microprocessor or a CPU), is adapted to cause an apparatus having the above mentioned features to execute the steps of a method having the above mentioned features.

Data processing which may be performed according to embodiments of the invention can be realized by a computer program, that is by software, or by using one or more special electronic optimization circuits, that is in hardware, or in hybrid form, that is by means of software components and hardware components.

In the context of the present application, the term "component carrier" may particularly denote any support structure which is capable of accommodating one or more components thereon and/or therein for providing mechanical support and/or electrical connectivity and/or optical connectivity and/or thermal connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above-mentioned types of component carriers.

In the context of the present application, the term "component carrier structure" may particularly denote a thin sheet handled and processed during and/or after manufacturing component carriers, for instance a panel, an array or a component carrier itself. Thus, a component carrier structure may particularly denote a panel comprising multiple connected preforms of component carriers, an array (such as a quarter panel) comprising multiple connected preforms of component carriers, a preform of a component carrier (i.e. a component carrier which is not yet readily manufactured), or a readily manufactured component carrier (such as a printed circuit board (PCB) or an integrated circuit (IC) substrate). However, it is also possible that the component carrier structure is a coupon.

In the context of the present application, the term "quality test" may particularly denote an assessment of the quality of a component carrier structure by analyzing a characteristic of one or more pre-defined test targets thereof. In such a quality test, it may be tested whether or not one or more such characteristic features of the component carrier structure meet(s) one or more quality criteria. Such quality criteria may include one or more qualitative quality criteria (such as presence or absence of a delamination of a layer structure as a qualitative error pattern or failure scenario) and/or one or more quantitative quality criteria (such as a thickness of a patterned copper layer in relation to a pre-defined range of acceptable thicknesses). Examples for determinable quality defects of component carrier structures are artefacts in terms of drill holes, hair inclusions, solder resist effects, short-circuiting between electrically conductive traces to be separated, etc. For example, a quality test of the component carrier structure may be carried out to check whether the component carrier structure complies with an industrial norm (for example IPC 6012, IPC-A-600, IPC-2221, etc.).

In the context of the present application, the term "pre-defined test target" may particularly denote a structural feature in an interior of the component carrier structure, exposed by material removal, which has been pre-defined as a characteristic item for assessing a quality of the component carrier structure. For example, a test target may be a drill hole or a layer structure in a (in particular laminated) layer stack of the component carrier structure comprising at least one electrically conductive layer structure (for instance a patterned copper foil and/or a copper filled laser via) and/or at least one electrically insulating layer structure (for instance a sheet comprising resin, such as epoxy resin, and optionally reinforcing particles such as glass fibers). In particular, a characteristic or an attribute of at least one test target of the component carrier structure may comprise one or more of a diameter of a drill hole (such as a laser drill hole or a mechanical drill hole, which may or may not be filled with an electrically conductive material such as copper), a distance between adjacent drill holes, a thickness of a layer structure (in particular a thickness of a patterned copper foil or layer), a planarity of a layer structure (for instance measured by means of a deviation of a layer structure from a purely planar configuration), delamination of a layer structure (i.e. a layer structure which has detached at least partially from an integral set of for instance laminated layer structures), etc.

In the context of the present application, the term "measuring progress of material removal" may particularly denote detecting information indicative of up to which extent the process of removing material from the component carrier structure has proceeded. This may include for example the measurement of an amount of material removed from the component carrier structure, the detection of a changed position of an exterior edge of the component carrier structure in view of the material removal, the detection of a changed position of a material removal unit or tool impacting the component carrier structure to remove material therefrom, the detection of sensor data (for instance contact pressure, feed rate and/or rotation speed) indicating an impact of the material removal unit on the component carrier structure, the detection of changes of sensor data sensed on a sacrificial structure and/or on a test target of the component carrier structure in view of the material removal (for example, but not limited to, abrasive material removal), etc.

In the context of the present application, the term "predefined material removal objective" may particularly denote a target exposure (for instance to make visible a maximum cross-sectional area) of at least one test target (for instance a drill hole) of the component carrier structure, which is desired in the context of the quality test. The aim or goal of the preparation process defined by the predefined material objective may be to expose one or more test targets of the component carrier structure to enable a meaningful quality test of the component carrier structure by analyzing the so exposed test target(s). For instance, a predefined material removal objective may be to expose a target examination plane of interest of the component carrier structure showing at least one test target in a predefined configuration (for instance showing a maximum diameter of a drill hole). In the context of the present application, the term "removing material for exposing a plane" may particularly denote a material removal in a horizontal, vertical or diagonal direction of the component carrier structure. Hence, the exposed plane can have any orientation (in particular horizontal, vertical, or diagonal).

In the context of the present application, the term "iteratively repeating a sequence of material removal, progress measurement and analysis" may particularly denote a repetition of the mentioned sequence of processes once, twice, three times or an even larger number of times until the measured material removal progress indicates that the above-described material removal objective has now been achieved.

According to an exemplary embodiment of the invention, a system of testing quality of a component carrier structure (such as a printed circuit board structure or a preform thereof) is provided in which part of the material of the component carrier structure may be removed by an abrasive process (such as grinding) for exposing an interior plane of interest to enable an exterior access to at least one test target for testing its properties and thus the component carrier structure's quality. Furthermore, a progress of the material removal process may be measured by a corresponding progress measuring unit preferably during (and/or after) said abrasive process. The measured progress may be compared with a predefined material removal objective (for example whether the abrasive process has exposed a test target of interest for the quality test, for instance a cross-section of a center of a drill hole). If said predefined material removal objective is not yet achieved as indicated by the measured progress, the sequence of material removal, progress measurement, and analysis of the measured progress in relation to the pre-defined material removal objective may be iteratively repeated until the progress measurement indicates that the material removal objective is finally achieved. The processed component carrier structure is then in a condition for image detection, determination of said test target(s) and evaluation of properties of said test target(s) in terms of quality testing. Highly advantageously, the described process can be fully automated to thereby increase throughput to meet even demanding requirements of an industrial scale (in comparison with conventional manual processing of component carrier structures). By an automated progress measurement and progress analysis in relation to a predefined material objective, a precision of the automated processes may be significantly improved (in comparison with conventional automated processing of component carrier structures). Hence, an exemplary embodiment of the invention may make it possible to assess quality of a component carrier structure with high reliability, high throughput and reasonable effort.

While the above-mentioned repetition(s) of the above described sequence of processes may have to be carried out in many cases and is thus quite likely in certain embodiments, it may be optional if the first sequence of processes is already successful. Hence, the material removal process can be sufficient already at first removal prior to first control by the above-mentioned control unit. Said control unit may thus be configured for at least once carrying out a check based on the analysis result whether the removal of material already hits a target point, or if one or more further iterations are to be carried out.

In the following, further exemplary embodiments of the apparatus, the method, the computer-readable medium, and the program element will be explained.

In an embodiment, the control unit is configured for iteratively repeating the sequence in a regulating loop, in particular by handling the component carrier structure within the regulating loop. Thus, the control unit (which may for instance comprise a processor) may carry out or control the repetition or iteration of the mentioned sequence involving the described feedback loop in a precisely definable and fully automatic fashion.

In an embodiment, the material removal unit is configured for removing material of the component carrier structure by grinding. In particular, grinding may denote an abrasive machining process that may use a grinding wheel (or another grinding body) as material removal or cutting tool. Each grain of abrasive may function as a microscopic single-point cutting edge, and shears a tiny chip from the component carrier structure. However, in other embodiments, material removal from the component carrier structure may be accomplished by other methods than grinding, for instance by laser processing or any kind of cutting.

In an embodiment, the material removal unit is configured for removing material of the component carrier structure by one of the group consisting of cross-sectional grinding and flat grinding. What concerns cross-sectional grinding, a cross section of the component carrier structure may be created that allows analysis at a plane that cuts through the plate-shaped component carrier structure. Cross-sectional grinding is a destructive technique cutting or grinding away a portion of the component carrier structure to expose an internal plane of interest for analysis. In an obtained cross section, the quality of drill holes can be assessed, the plating quality and thickness in vias can be assessed, and other test targets can be analyzed as well. As an example for such other test targets, voids in the materials of the component carrier structure may be made accessible which indicate the quality of a lamination process. What concerns flat grinding or surface grinding, such a technique may be used to produce a smooth finish on a flat surface of the component carrier structure. Flat grinding may be denoted as an abrasive machining process in which a spinning wheel (or any other body) covered with rough particles cuts chips from a main surface of the component carrier structure thereby accessing a main surface of an interior layer of the component carrier structure.

In an embodiment, the apparatus comprises a polishing unit configured for polishing an exposed surface of the component carrier structure after removing material. Polishing may denote the process of creating a smooth surface by rubbing it or using a chemical action, leaving a surface with a reduced roughness. In contrast to grinding, polishing does not remove a noteworthy amount of material from the surface of the component carrier structure, but simply enhances planarity by flattening the surface. Polishing may use multiple stages, starting with a rougher abrasive, wherein each subsequent stage may use a finer abrasive.

In an embodiment, the material removal unit is configured for removing material of the component carrier structure by a coarser grinding stage followed by a finer grinding stage. Coarse grinding may use a larger grain size than fine grinding. Even more than two grinding stages are possible, for instance using at least three different grain sizes, wherein the grain size is reduced from grinding stage to grinding stage. By such a multi-stage grinding process, the surface of the component carrier structure subjected to material removal may be treated gently without introducing artefacts by the material removal process.

In a preferred embodiment, the progress measuring unit is configured for measuring the progress during the removal of material by the material removal unit. Advantageously, the material removal may be measured on-the-fly, i.e. while the material removal process takes place. This accelerates the sample preparation and allows a particularly precise monitoring and control of the material removal process while strongly suppressing the risk of an excessive removal of material. Additionally or alternatively, the progress of the material removal process may also be measured after the material removal process or between two subsequent material removal stages.

In an embodiment, the progress measuring unit is configured for measuring the progress by optically detecting an image of the component carrier structure. More specifically, an optical camera may capture an image of an exposed surface of the component carrier structure during and/or after the material removal as a basis for a subsequent determination of one or more exposed test targets used for the quality test.

In an embodiment, the progress measuring unit is configured for measuring the progress by electrically measuring an electric signal at an electrically conductive structure of the component carrier structure, in particular during and/or after material removal. In particular, the electrically conductive structure may belong to a test target or to a sacrificial structure of the component carrier structure. During material removal, part of the test target and/or at least part of a sacrificial structure may be removed from the component carrier structure as well. By connecting an electrically conductive test target or an electrically conductive sacrificial structure with one or more electrodes of the progress measuring unit, it may be possible to detect an electric signal of said electrically conductive structure which may be characteristically changed during the material removal process due to the at least partial removal of the electrically conductive structure. In particular, it may be possible to detect the ohmic resistance of the electrically conductive structure which will increase with continued removal of the electrically conductive structure. Thus, the mentioned electric signal may be a fingerprint of the progress of the material removal process. Hence, the progress measuring unit may be configured for measuring the progress by detecting an electric signal of the electrically conductive structure to be at least partially removed during the material removal for exposing the at least one test target, wherein the electrically conductive structure is configured to be used for detecting a progress of the material removal up to an exposure of the at least one test target in accordance with the predefined material removal objective.

In an embodiment, the progress measuring unit comprises a removed material quantification unit configured for quantifying an amount of removed material. By collecting (for instance on a weighing machine) chips of material removed from the component carrier structure (for instance by grinding), information concerning the progress of the material removal process can be obtained allowing to stop the material removal process when a desired test target or a previously hidden plane of interest has been exposed, preferably when a center of a drill hole has been reached.

Additionally or alternatively, other concepts of determining a progress of a material removal process (in particular a grinding progress) may be implemented as well. Examples are the detection of a changed position of an exterior edge of the component carrier structure in view of the material removal, the detection of a changed position of a material removal unit or tool impacting the component carrier structure to remove material therefrom, the detection of sensor data (for instance contact pressure and/or rotation speed) indicating an impact of the material removal unit on the component carrier structure, the detection of changes of sensor data sensed on a sacrificial structure and/or on a test target of the component carrier structure in view of the material removal, etc.

In an embodiment, the progress measuring unit is configured for measuring the progress based on a spatial advancing of the material removal unit during removing material of the component carrier structure. During removing material from the component carrier structure by an abrasive process (such as grinding), the abrasive material removal unit (for instance a grinding device) may move forward to extend up to and into an exterior edge of the component carrier structure from which material is removed. Hence, the spatial displacement of the material removal unit may be used as a measure for the progress of the material removal process.

In an embodiment, the progress measuring unit is configured for measuring the progress based on a detection of a contact pressure (in particular a time dependence of a contact pressure) of the material removal unit against the component carrier structure during removing material of the component carrier structure. When an abrasive material removal unit (such as a grinding device with a rotating grinding tool) presses against a surface of the component carrier structure from which material is to be removed, the contact pressure may provide information concerning the progress of the material removal process. For instance, a pressure sensor, a strain sensor, etc., may be integrated into the material removal unit, preferably at or close to an interface to the component carrier structure. For instance when the material removal of the component carrier structure proceeds from the removal of resin to the removal of copper (for instance filled in a drill hole), a discontinuous increase of the contact pressure may be detected. When however the material removal of the component carrier structure proceeds from the removal of resin into a non-plated hollow drill hole, a discontinuous decrease of the contact pressure may be detected. When the construction of the component carrier structure (for instance a predefined coupon) is known, the detection of the time dependence of the contact pressure in combination with the preknown construction of the component carrier structure may allow to derive information concerning a progress of the material removal process.

In an embodiment, the progress measuring unit is configured for measuring the progress based on a detection of a rotation speed of a rotatable body of the material removal unit during removing material of the component carrier structure. The rotation speed of, for instance, a rotating grinding tool removing material from the component carrier structure may depend on the material of the component carrier structure being presently removed. Thus, changes in the rotation speed (which may be detected by a corresponding sensor) of the material removal unit may provide information concerning the progress of the material removal unit into inhomogeneous material of the component carrier structure. Hence, when the construction of the component carrier structure (which may comprise resin and copper) is pre-known, the time dependence of the determined rotation speed may be indicative of a present position and hence a spatial advancing of the material removal tool during removing material from the component carrier structure.

In an embodiment, the apparatus comprises an initial measuring unit configured for measuring the component carrier structure initially before the removal of material. The material removal unit may be configured for removing material of the component carrier structure based on a measuring result of the initial measuring unit. When the position and/or orientation and/or outline of the component carrier structure is measured, the subsequent material removal process can be adjusted or adapted to such a measurement result. In particular, it may also be possible to initially measure a deviation from a for instance rectangular target shape of the component carrier structure and to adjust the material removal process correspondingly. For instance, it may be possible that a front edge of the component carrier structure subjected to the material removal is slightly slanted with respect to an advancing direction of the material removal unit. Such a spatial artifact may be considered, corrected or compensated by the material removal process.

In an embodiment, the apparatus comprises an alignment unit configured for aligning the component carrier structure before the material removal, in particular based on a detection of at least one alignment structure or feature of the component carrier structure. Preferably, said alignment unit may comprise a multi-axis robot, most preferably a hexapod, for obtaining excellent alignment accuracy. In order to ensure a proper orientation of the component carrier structure, the apparatus may automatically determine the position of one or more alignment markers of the component carrier and may adjust the position and/or orientation of the component carrier structure before continuing the processing. This improves the accuracy of the
quality test.

In an embodiment, the apparatus comprises a detection unit configured for detecting image data of an interior of the component carrier structure after said removing of material. In this context, the previous interior plane of the component carrier structure being imaged by the detection unit (for instance comprising a camera) may be exposed by the prior material removal stage. The results of the image detection may then be forwarded to a determination unit for determining test targets.

According to the invention, the apparatus and the method further comprise a determining unit configured for determining at least one of the test targets of the component carrier structure, and an evaluation unit configured for evaluating a characteristic of the determined at least one test target of the component carrier structure for assessing its quality. Also in a fully automated manner, one or more test targets may be determined from the abrasively treated component carrier structure. An evaluation unit may then evaluate the results of this determination to derive a result of the quality test.

In an embodiment, the apparatus comprises a monitoring unit, in particular an X-ray device, configured for monitoring, in particular for continuously monitoring, the component carrier structure at least during at least part of the above-mentioned sequence. Such an X-ray device may also provide an image of an interior of the component carrier structure and may for instance show the position of a test target in an interior prior to the material removal. By using this information about the interior construction of the component carrier structure, the material removal process may be rendered more accurate.

In an embodiment, the material removal objective is to reach a center of a test target (in particular of a drill hole, or of an electrically conductive structure such as a pad or line) of the component carrier structure. A drill hole may have a circular cylindrical cross-section (for instance when formed by mechanically drilling) or a conical or frustoconical cross-section (for instance when formed by laser drilling) in a cross-sectional plane perpendicular to main surfaces of a plate-shaped component carrier structure. Such drill holes may hence have a central axis. For testing quality of such a drill hole-type test target, it may be advantageous to expose a maximum area of the drill hole in a cross-sectional plane perpendicular to main surfaces of a plate-shaped component carrier structure. Hence, such a configuration may be defined as material removal objective to be achieved.

In an embodiment, the apparatus comprises a mechanical stopper configured for abutting against the material removal unit for disabling an excessive material removal of the component carrier structure by the material removal unit. For example, such a mechanical stopper may be embodied as one or more robust mechanical stops. When the material removal unit advances towards and into the component carrier structure, the material removal unit may be automatically stopped at the position of the mechanical stopper. Thereby, an excessive material removal may be rendered impossible. Advantageously, the mechanical stopper may be arranged at a position so that, when the material removal unit abuts against the mechanical stopper and is thereby prevented from advancing further into the component carrier structure, the material removal unit will advance only up to a position corresponding to the predefined material removal objective. In order to ensure that the mechanical stopper is mechanically stronger than the material removal unit, its front face may be hardened, for instance may be made of diamond material.

In an embodiment, the apparatus is configured for carrying out the described process without human intervention. Correspondingly, the method may comprise carrying out the described process without human intervention. Highly advantageously, none of the mentioned processes in terms of validity assessment of the coupon and the assigned component carriers requires any user intervention. This not only reduces human resources effort in terms of quality testing of component carrier structures, but also renders the quality test more objective, hence more meaningful and faster.

In an embodiment, the component carrier structure comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In an embodiment, the component carrier structure is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier structure is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming through holes through the laminate, for instance by laser drilling or mechanical drilling, and by filling them with electrically conductive material (in particular copper), thereby forming vias or other through hole connections. The (for instance partially) filled hole may connect the whole stack (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers) or other reinforcing particles (such as reinforcing spheres, in particular glass spheres).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal, and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (e.g. based on polyphenylether PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials (wherein "DK" may refer to the real part of the dielectric constant) may be applied in the component carrier as electrically insulating structures.

In an embodiment, the at least one electrically conductive layer structures comprises at least one of the group consisting of copper, aluminum, nickel, silver, gold, palladium, and tungsten. Although copper is usually preferred, other materials or coated versions thereof are possible as well, in particular coated with supra-conductive material such as graphene.

At least one component, which can be embedded in the stack, can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay could be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such as solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), gold (in particular Hard Gold), chemical tin, nickel-gold, nickel-palladium, Electroless Nickel Immersion Palladium Immersion Gold (ENIPIG), etc.

The aspects defined above and further aspects of the invention are apparent from the examples of embodiment to be described hereinafter and are explained with reference to these examples of embodiment.
Figure 1 illustrates a flowchart of a method of carrying out a quality test of a component carrier structure according to an exemplary embodiment of the invention.
Figure 2 schematically illustrates an apparatus for carrying out a quality test of a component carrier structure according to an exemplary embodiment of the invention.
Figure 3 illustrates details of an apparatus for carrying out a quality test of a component carrier structure according to an exemplary embodiment of the invention.
Figure 4 illustrates an apparatus for processing a component carrier structure for a quality test according to an exemplary embodiment of the invention.
Figure 5 illustrates a coupon as an example for a component carrier structure and comprising a sacrificial structure used for progress control of a material removal process according to an exemplary embodiment of the invention.
Figure 6 illustrates a block diagram of a method of processing a component carrier structure for a quality test according to an exemplary embodiment of the invention.
Figure 7 illustrates a component carrier structure with test targets prior to a material removal process and being initially and/or continuously monitored for adjusting a material removal process according to an exemplary embodiment of the invention.
Figure 8 illustrates a component carrier structure with test targets subjected to a material removal process by a material removal unit, wherein an advancing of the material removal unit and/or an amount of removed material may be monitored for progress control according to an exemplary embodiment of the invention.
Figure 9 illustrates a component carrier structure with test targets and a sacrificial structure subjected to a material removal process by a material removal unit, wherein an electric signal may be detected at the sacrificial structure and/or a test target for progress control according to an exemplary embodiment of the invention.
Figure 10 illustrates a component carrier structure with test targets and a mechanical stopper for disabling an excessive material removal in terms of progress control according to an exemplary embodiment of the invention.

The illustrations in the drawings are schematic. In different drawings, similar or identical elements are provided with the same reference signs.

Before referring to the drawings, exemplary embodiments will be described in further detail, some basic considerations will be summarized based on which exemplary embodiments of the invention have been developed.

According to an exemplary embodiment of the invention, an apparatus for and a method of processing a component carrier structure (such as a coupon, a PCB or a preform thereof, a panel, etc.) is provided in which material of the component carrier structure may be removed (in particular by grinding, milling, chipping, machining, cutting, etc.). A progress of the material removal process may be measured. Based on a result of said measuring it may then be analyzed whether a pre-defined objective, goal or target of the material removal process has been achieved (for instance whether a previous interior cross-sectional plane of interest of the component carrier structure has been exposed and shows a test target - for instance a drilled hole - in a desired view). If this is the case, an image of the now exposed cross-sectional plane with the one or more test targets being visible in a desired fashion may be detected (preferably after polishing), and said one or more test targets may be determined and evaluated for deriving attributes or characteristics of the component carrier structure under analysis. If the above mentioned objective is not yet achieved, the processes of material removal by grinding the component carrier, measuring the grinding progress and/or results, and assessing whether the grinding objective has been achieved may be iteratively repeated a second time or multiple additional times until the grinding objective is achieved. Hence, a regulating feedback loop may be implemented which continues grinding until a predefined grinding success in terms of exposing a test target is achieved. Such an automated process may advantageously overcome conventional limitations in terms of throughput of manual grinding while simultaneously overcoming conventional imitations concerning limited precision of automated grinding processes.

According to an exemplary embodiment of the invention, a control system enabling a precise alignment and progress-monitoring during a grinding and polishing process is provided. This may enable a precise alignment of sample and grinding/polishing equipment. Furthermore, this may make possible to monitor progress during grinding and polishing processes. In particular, a closed control loop (preferably implementing online measurement of grinding progress) may be implemented in terms of alignment and progress control.

More specifically, such a control system for grinding and polishing processes may enable a precise alignment of sample and grinding/polishing equipment via a microscope/camera combination. Furthermore, progress during grinding and polishing doses may be monitored. More specifically, continuous monitoring of sample alignment, the progress of grinding/polishing and grinding/polishing quality may be continuously monitored by optical, electrical, X-ray, mechanical or and/or chemical features and methods which may be integrated into the sample. Highly advantageously, a closed control loop (involving online measurements) may be introduced for alignment and progress (in particular, sensors may be implemented in the sample as well as in the control system). Moreover, a fully automated quality test apparatus implementing the above and/or other features may be provided. Taking the above-mentioned measures may allow to obtain a preferably fully automated target preparation system with high precision and throughput.

Hence, advantageous features of the apparatus for processing a component carrier for a quality test and in particular its control system may be one or more of the following:
- An automated grinding (and preferably polishing) process is provided, for instance supported by a camera-based and/or microscope-based control.
- The above-mentioned grinding process may be provided with a camera control system.
- The automated grinding (and preferably polishing) process may be carried out with a properly aligned component carrier structure, in particular using one or more alignment marks on and/or in the component carrier structure.
- The grinding process may be carried out with grinding thickness monitoring, or more generally with a measurement of material removal progress.
- The grinding progress may be measured with an observation of a degree of grinding (descriptively speaking, a grinding guide may thus be provided).
- More specifically, a fully automated grinding process may be executed with the above-mentioned grinding guide or control track.
- It may also be possible to use one or more PCB features for analysis and as reference for the alignment.
- In particular, a feedback control loop may be advantageously provided, so that not only an image of an actual position forms the sole basis for the control.

Advantageously, an exemplary embodiment of the invention may provide a control system with individual control stations of the overall system. A respective cross sectional image may be used for purposes such as coupon alignment, grinding progress, quality of cross sectional image. Optionally, cleaning and/or polishing quality may also be detected by an apparatus according to an exemplary embodiment of the invention. A proper alignment between the component carrier structure and the apparatus may be ensured by using a microscope (which may detect alignment markers on the component carrier structure). Moreover, an exemplary embodiment may implement an X-ray and/or electrical measurement (for instance for characterizing buried vias).

Hence, an exemplary embodiment may automate a preparation process of preparing a component carrier structure for a quality test. In particular, an advantageous control loop may recognize, align, prepare and control the device under test (DUT) type component carrier structure. This control loop may remain in place until the desired result is available.

A process according to an exemplary embodiment of the invention will be described in the following in further detail: In terms of the material removal for exposing a test target of the component carrier structures, the component carrier structure may be firstly subjected to a coarse grinding process followed by a fine grinding process. During the coarse grinding, a grain size may be larger (for instance at least 200 µm) than during fine grinding (for instance not more than 100 µm). While a substantial amount of material is removed from the component carrier structure during grinding, subsequent polishing may substantially planarize the surface without noteworthy material removal and with even small grain sizes (for instance not more than 20 µm). Descriptively speaking, polishing may reduce the surface roughness without substantial material removal. For example, grinding may be a wet grinding process supported by water rinsing of a grinding body during rotation. During polishing, an emulsion with diamond particles or the like may be used.

In terms of alignment of the component carrier structure with respect to an automated apparatus and in particular its material removal unit, a robot (such as a multi-axis robot) or any other appropriate entity of a handling unit may grip the component carrier structure (for instance a coupon), may align the component carrier structure (for instance after having detected one or more alignment structures of the component carrier structure), may measure a spatial distance with respect to the component carrier structure and may then control the material removal unit to approach the component carrier structure for the material removal. For this purpose, it is for instance possible that a first optical measurement is made prior to the material removal and that a second optical measurement is carried out after the material removal. Before an optical measurement, the imaged surface of the component carrier structure may be cleaned. If said second optical measurement indicates that the material removal objective has not yet been achieved (in particular since a test target such as a drill hole is not yet exposed or is not yet exposed to a desired degree), one or more further iterations of the material removal may be carried out. These iterations may be repeated until the material removal objective is met, for instance until a measured parameter of a test target (in particular a drill hole diameter) has reached a predefined target value (for instance a drill hole diameter of 50 µm). For instance, a respective optical measurement can be carried out between each two subsequent material iterations. Preferably, a progress of the material removal process may be measured during and/or after each iteration thereof. For example, this can be accomplished by an electrical measurement on an electrically conductive structure of the component carrier structure during grinding, wherein the electric detection signal may become weaker (and may optionally finally vanish) when the electrically conductive structure is partially (and optionally finally completely) removed during the material removal process. It is also possible to measure, additionally or alternatively, a positional advancing of a grinding device so that it can be concluded when a final position of the grinding device - and correspondingly a target configuration of the component carrier structure - is achieved. Also an X-ray analysis may be made during continuously monitoring a grinding process. Also a planarity of a cross-sectional plane may be monitored. Preferably, polishing is only initiated when the monitoring of the previous grinding process has been completed. The described process may be carried out for cross-sectional grinding or flat grinding.

In an embodiment, a method of testing quality of the component carrier structure may comprise the following processes: A handling unit (such as a robot) grips a component carrier structure (such as a coupon). The component carrier structure is aligned and positioned. Thereafter, material of the component carrier structure is removed in one or multiple stages, in particular grinding stage(s). Optionally, a surface of the component carrier structure exposed by the material removal may then be cleaned. A (for instance optical and/or electrical) measurement may be carried out for assessing whether a progress of the material removal process has reached a predefined material removal objective. If this is not yet the case, the sequence of material removal as well as progress measurement and analysis may be repeated any desired number of times until the material removal objective is achieved. Then, the exposed surface with the test target in its desired configuration for the quality test may be polished, and an optical measurement may be carried out as a basis for a subsequent defect analysis concerning the exposed test target(s). Hence, determination of said test target(s) and evaluation of a characteristic thereof may then be carried out. The quality test may than the completed. For instance, one or more of the criteria mentioned in chapter "3.6 Structural Integrity" of IPC-6012D (version: September 2015) may be considered for evaluating a defect.

Examples for variables having an influence on cross-sectioning of component carrier structures (see a more detailed discussion of the individual variables below) are a grinding body used for material removal, alignment (for instance making use of a handling arm), pressure applied during grinding and/or polishing, rotation speed during grinding and/or polishing, control in particular of a material removal from a component carrier structure (more specifically material removal progress control), cleaning (of component carrier structure and/or grinding body) to avoid carryover, heating or cooling, and thermal and mechanical loads.

What concerns grinding, adjustable parameters are grain size, contact pressure, and rotation speed of abrasive medium. Grain may also be adjusted for a grinding machine. Polishing of a cross-sectional surface of the component carrier structure may be carried out using a diamond suspension (wherein rotation may be synchronized or reciprocal). Optionally, immersion and/or filling of a component carrier structure may be possible to prevent smearing of copper holes.

With respect to a used grinding body for material removal, it may be advantageous that the material removal process does not generate excessive heat to keep the laminate of the component carrier structure intact. Preferably, the material removal process may be carried out at a temperature significantly below the glass transition temperature Tg (for example at least 10% below Tg on the Celsius scale or on the Kelvin scale) of the resin material of the component carrier material. For example, water can be used as a cooling and/or cleaning medium.

For removing material of the component carrier structure, grinding may be preferred. However, material removal can also be accomplished by (for instance wire) cutting, wire eroding, plasma treatment, laser treatment, sandblasting, water jetting, milling, sawing, treatment by gate shears, ion beam treatment and/or punching.

Preferably, the grain size may be (in particular at the end of the material removal) fine enough that subsequent polishing is supported. Grain size may be selected depending on a used polishing suspension. For example, 3 µm grains may be applicable for only a certain degree of grinding.

In order to suppress a variance of planarity of a ground and/or polished surface of the component carrier structure, it may be advantageous to avoid excessive heat and cold. Furthermore, thermal and mechanical loads should be kept low.

When designing a handling arm of the handing unit, slipping and/or turning of the component carrier structure should be kept as low as possible. This advantageous boundary condition may influence the choice of a maximum rotation speed.

Next, embodiments of the grinding process will be explained. Advantageously, an iterative grinding control process may be carried out. Grinding disks (or plates) may be arranged horizontally or vertically, or at a special angle if required or desired (in view of an implemented type of grinding).

What concerns the control of a progress of the material removal, a camera may be used for monitoring grinding progress. For instance, such a camera may be arranged on and/or in a grinding body. This may promote planarity and/or alignment of the treated surface of the component carrier structure. Progress control may also be accomplished by an electric measurement, for instance by contacting a copper structure which is removed partially or entirely at a certain material removal progress state, which can be detected by a change of an electric signal. Additionally alternatively, progress control may be based on one or more mechanical stops (for instance having a sufficiently hard surface, preferably a diamond surface), against which a grinding body abuts when a predefined progress of the material removal process is achieved. Also a resistance measurement on a grinding body may be used for progress control. In other embodiments, progressive feed may be measured in terms of progress control. For example referring to a through hole, the moment that such a hole is opened may result in a significant pressure drop. When a micro via is reached, the impact on pressure may be the other way around, i.e. a pressure increase, or resistance increase may be detected. Grinding metallic via material rather than softer resin material may increase the pressure. If an electric signal is measured at the micro via and the electrically conductive material of the micro via is removed, the electric resistance may increase, which may be detectable as well. In yet another embodiment of progress control, discoloration for instance of water upon target achievement may be detected. Also a resistance measurement (for instance of a sacrificial structure removed during grinding) may be used for progress control. In yet another embodiment relating to progress control, sound detection, tribometer-based detection, a pin pressing on a grinding disc (optionally combined with a light barrier), etc., may be used. Once a center of a drill hole is detected, then grinding may stop.

Preferably, progress can be measured at or close to a test target. Still referring to progress control of a grinding process, a hard stop may be possible. However, also iterative grinding processes are possible.

In an embodiment, contact pressure between grinding body and component carrier structure may be measured. For instance, this may be accomplished in an automated manner by a pressure regulator (regulating for instance depending on force). During material removal, the pressure can remain constant or may be varied. A smaller number of grinding bodies can be balanced with time, pressure, rotation. It may also be possible to apply a variable pressure depending on throughput, quality target, sample thickness. Maximum pressure may be regulated in such a way that no damage of the component carrier structure occurs, in particular at or around test targets such as drill holes. In particular, the contact pressure can be selected depending on how the component carrier should be ground (for instance grinding along layers, grinding against layers, etc.). Care should be taken that cutting preparation neither enhances nor reduces quality problems in the component carrier structure.

What concerns rotation speed and type, it may be advantageous to generate heat only in a range below a predefined maximum value. A rotation direction may be synchronized or may be opposite. A gripping or handling device (such as a clamping device, a handling fixture, a hexapod, etc.) can oscillate quickly.

Parameters which can be adjusted in terms of rotation are rotation time, contact pressure, type of rotation, material of the component carrier structure, grain, etc.

Concerning alignment or orientation of the component carrier structure during its treatment for carrying out the quality test in an automated way, a camera may determine whether the component carrier structure sample is positioned correctly before a first grinding. If necessary, the position of the component carrier structure may be corrected to ensure a proper alignment (for instance based on a comparison with external reference holes that are preferably not coppered; such reference holes may for instance be drilled or etched in a photo process). Alternatively, a mechanical alignment process (for instance using an alignment pin) may be carried out.

An objective of the alignment may be that a target plane and a grinding medium should be oriented in parallel. This may be achieved by correspondingly influencing medium, grinding body, turning one or even all of the involved components, etc.

Still referring to alignment, a camera image may capture reference points and target points to be viewed. Such data may define a target plane (software-supported, mechanically, etc.) and may bring a target plane parallel to the grinding medium. In the further course of alignment control, limiting factor may be the combination of hexapod/grinding speed/maximum force, so that the alignment remains which corresponds to the mechanical stability of the overall system.

Now referring to cleaning of the component carrier structure, one embodiment may clean the component carrier structure during grinding. In an iterative approach, each new grinding stage (for instance fine grinding following coarse grinding) may be preceded by a cleaning stage. Cleaning may ensure that no carryover of particles takes place. For instance, particles may be blown away, sucked away, evaporated, burnt, stripped off, brushed, rinsed, etc., in terms of cleaning. For instance, continuous cleaning may be carried out during the grinding process. Suction, rinse (preferably bath or sink), strip off, blow away, ultrasonic bath (shake out) or other cleaning units may be implemented. Advantageously, very small cracks may be rinsed out by cleaning. After cleaning, it may be advantageous that the remaining particles should be at the maximum equal in size to or smaller in size than the grain size used for grinding in the next process.

What concerns coupon design, it may be standardized, or may deviate. Any deviation may be coordinated with a user. For instance, a coupon-type component carrier structure may be provided with one or more registration holes, a wear sensor, etc.

Examples for quality criteria or characteristics in terms of assessing quality of a component carrier structure are a sharp edge (preferably 90°), a radius near zero, planarity, a tolerance below a predefined threshold value (for instance 10% or preferably less than 10%, having a tolerance of not more than 7%). A further quality feature of a component carrier structure is that it is should be preferably scratch-free in an image at 100x magnification. Furthermore, the component carrier structure should be free of gaps (in particular between sample and embedding agent, more particularly between conductive layer and embedding agent, especially between copper and embedding agent). Resins may shrink when embedding (fast curing embedding agents have a lot of volume loss, slow curing agents have little volume loss), but shrinkage should not be excessive.

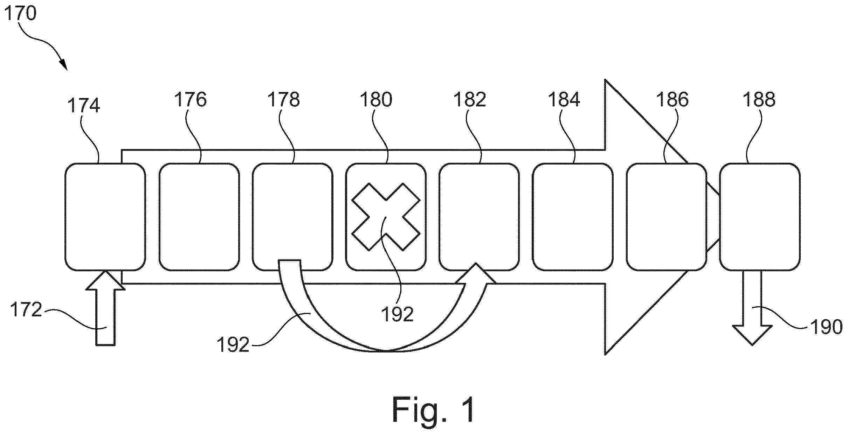

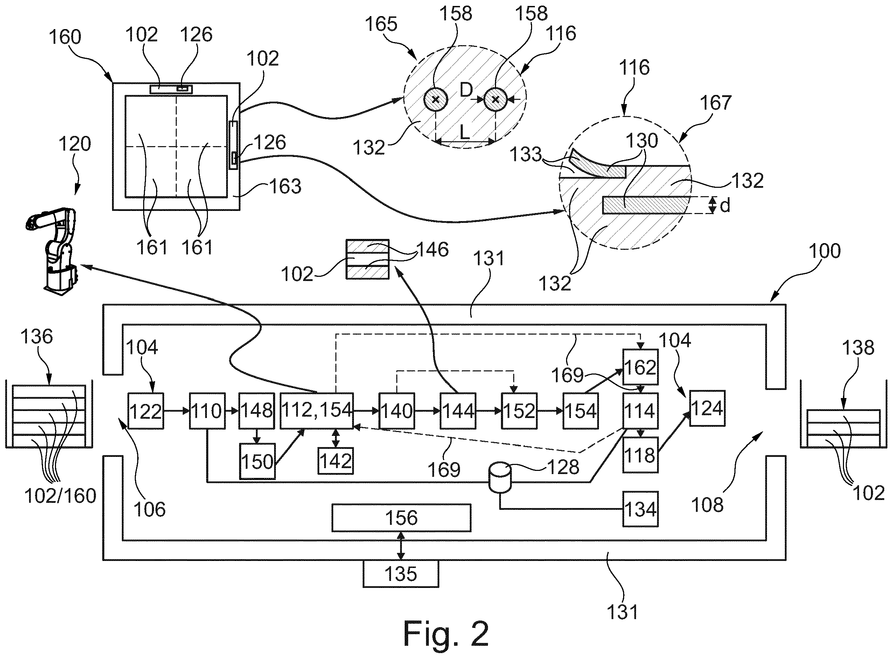

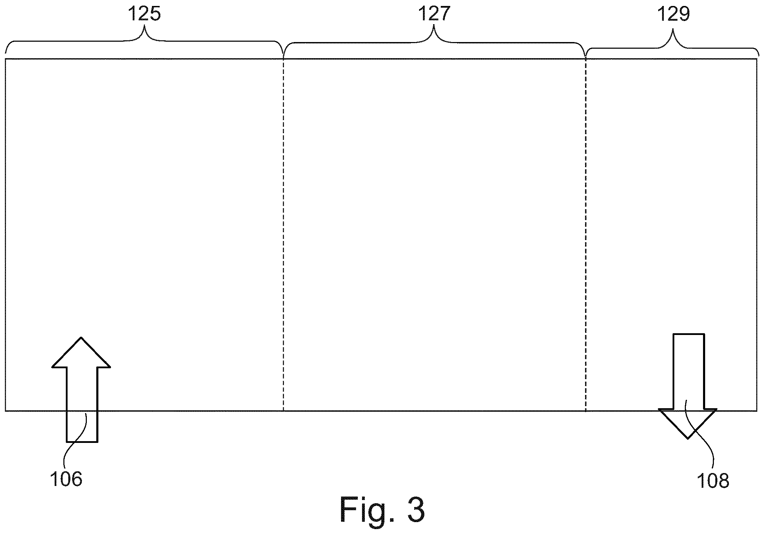

**Figure 1** illustrates a flowchart 170 of a method of carrying out a quality test of a component carrier structure 102 according to an exemplary embodiment of the invention. The reference signs used for the description of Figure 1 refer to the embodiments of Figure 2 or Figure 3. Preferably, the mentioned component carrier structure 102 may be a coupon forming part of a panel and used for testing component carriers (such as printed circuit boards (PCBs) or integrated circuit (IC) substrates). However, the component carrier structure 102 may be alternatively a panel or an array (such as a quarter panel) comprising multiple connected preforms of component carriers, or a preform of a component carrier or a readily manufactured component carrier.

Advantageously, the method of flowchart 170 may correspond to the execution of a quality test of the component carrier structure 102 by an automated apparatus 100. Preferably, the method may comprise carrying out the quality test without human intervention between an inlet 106 - corresponding logically to input 172 - and an outlet 108 - corresponding logically to output 190 - of said apparatus 100. In other words, inlet 106 of apparatus 100 corresponds to input 172 of the method, whereas outlet 108 of apparatus 100 corresponds to output 190 of the method. More specifically, an automated process for cross section preparation and visual inspection as well as measurement of a component carrier structure 102 is provided. Preferably, no manual work occurs, and the entire process may be automated. For this purpose, the test coupon-type component carrier structure 102 may be configured for automated handling and for machine-readable serialization.

As indicated with reference sign 172, the component carrier structure 102 may be input into apparatus 100.

Referring to a block 174, a coupon may be inserted as component carrier structure 102 into the apparatus 100 and may hereby be handled fully automatically by a robot 120. More specifically, the coupon may be a component carrier structure 102 which may for example be constructed or designed in accordance with IPC-2221. The component carrier structure 102 may provide traceability information to the apparatus 100. For this purpose, the method which may be carried out using apparatus 100 may comprise automatically identifying the component carrier structure 102 which shall undergo the quality test. For instance, it may be possible to register the coupon-type component carrier structure 102 in a list. Multiple coupons may be sorted. For traceability purposes, it may be possible to assign information such as lot number, panel number, array number, x/y information, cross section number, a report number, a request identifier, etc., in a data set assigned to a respective component carrier structure 102. For instance, such data sets may be stored in a database 128.

Referring to a block 176, the component carrier structure 102 which may still be integrally connected with the rest of a panel or the like may be singularized or separated, for instance by milling or cutting the component carrier structure 102 out from a larger body 160 such as a panel. For this purpose, it may be possible to search a defined position of the component carrier structure 102 in the larger body 160 and cut it out. As a result, a test sample in form of the separated component carrier structure 102 may be obtained. For instance, cutting out the component carrier structure 102 may be accomplished in accordance with a smallest plated through hole or corresponding to a user definition.

Referring to a block 178, the component carrier structure 102 may then be subjected to thermal stress, for instance by executing a solder float test. For example, the component carrier structure 102 may be immersed in molten solder for subjecting thermal stress to the component carrier structure 102. As an alternative to a solder float test, it may also be possible to carry out an alternative thermal stressing method, e.g. reflow simulation.

Referring to a block 180, the component carrier structure 102 may or may not be subjected to an encapsulation process for simplifying handling and/or for buffering stress during the subsequent quality test. While conventional manual quality tests of component carrier structures may require encapsulation before assessing quality, such an embedding may be omitted according to an exemplary embodiment of the invention involving a fully automatic quality test of the component carrier structure 102. If carried out optionally, the encapsulation process may put the component carrier structure 102 into embedding material, such as resin, for further preparation. However, such an embedding can be advantageously skipped (as indicated with reference sign 192) in other embodiments, since automated handling according to an exemplary embodiment of the invention can also be accomplished without such an encapsulation.

Referring to a block 182, it may then be possible to remove material of the component carrier structure 102 for exposing an interior of the component carrier structure 102 to be subjected to the quality test. More specifically, a microsection (in particular cross-section) of the component carrier structure 102 may be created. For this purpose, the component carrier structure 102 may be ground and subsequently polished up to a defined position (preferably up to a center of a via or drill hole or a pattern). For instance, different stages of sandpaper treatment and polishing may be carried out. For grinding, it may for instance be possible to use sandpaper with different grains (for instance using one or more of the following grains: 60, 180, 1200, 2000).

Referring to block 184, the method may then comprise determining one or more pre-defined test targets 116 (such as plated vias and their properties) of the component carrier structure 102 after said material removal. Furthermore, the method may comprise evaluating characteristics or attributes of the one or more test targets 116 of the component carrier structure 102 for assessing the quality of the component carrier structure 102. When skipping block 180, the method may comprise determining the at least one pre-defined test target 116 based on a non-encapsulated component carrier structure 102, otherwise based on an encapsulated component carrier structure 102. In particular, a visual analysis of the cross-section of the component carrier structure 102 may be carried out, preferably in an automated way. For example, x/y dimension measurements may be carried out (for instance inspecting a build-up, a copper thickness, etc.). In particular, the visual check may include an analysis of certain defects. During said inspection, one or more of the following test targets 116 and assigned characteristics may be considered: multilayer build up; plated through hole properties (like wall properties, land characteristics); quality of surface roughness (for instance, surface roughness may be determined corresponding to the Ra scale and/or corresponding to the Rz scale). In terms of roughness, the roughness value Rz may be used as a criterion for the presence of scratches at an exposed surface (in particular a cross-section) of the component carrier structure 102, whereas the roughness value Ra may be used as a criterion for the quality of the material removal process (in particular grinding process). For instance, a quality criterion may be that the roughness of a surface of the component carrier structure 102 exposed by grinding and/or polishing should not be larger than the roughness of a grinding disc and/or polishing paste used in a preceding material removal stage. If this criterion was not fulfilled, it may be concluded that an artifact has been introduced by an earlier material removal stage. For instance, a measurement resolution of at least 1 µm may be obtained. For example, a quality test may be carried out in accordance with IPC-6012, IPC-A-600, etc.

Referring to block 186, the method may comprise creating and storing a report with pre-defined properties. The report may summarize the quality test and its conclusions. This may ensure a proper documentation of the quality test.

Referring to block 188, the method may then comprise archiving the analyzed component carrier structure 102 and the quality test. In particular, this may involve sample storage, storage of electronic documentation, etc.

As indicated with reference sign 190, the component carrier structure 102 may then be output from the apparatus 100.

**Figure 2** schematically illustrates an apparatus 100 for carrying out a quality test of a component carrier structure 102, here embodied as a coupon, according to an exemplary embodiment of the invention. As indicated by a circumferential casing 131 of the apparatus 100, the entire quality test can be carried out in an automated manner within a closed cell.

On the top left-hand side of Figure 2, a plan view of a planar sheet-like body 160 is illustrated, which can be a panel for manufacturing a plurality of component carriers (such as printed circuit board) in a batch procedure. The illustrated panel may for instance have a dimension of 18 × 24 inch² or more. A central main area of the panel may be subdivided into multiple arrays 161 (four quarter panels in the shown embodiment), each comprising multiple PCBs. In a frame 163 surrounding the component carriers, one or more strip-shaped test coupons may be formed as component carrier structures 102. Advantageously, at least one horizontally extending component carrier structure 102 and at least one vertically extending component carrier structure 102 may be foreseen, so as to make it possible to carry out the quality test to identify potential structural defects in two perpendicular directions.

Referring now to apparatus 100 in further detail, an inlet accommodation unit 136 is arranged at an inlet 106 of said apparatus 100 and is configured for accommodating a plurality of component carrier structures 102 in a stacked fashion prior to testing. Hence, the coupon-type component carrier structures 102 may be inserted into the inlet accommodation unit 136 after separation from panel-type body 160. Alternatively, it is possible to stack the larger bodies 160 each including at least one component carrier structure 102 in the magazine-type inlet accommodation unit 136.

A robotic handling unit 104 is configured for handling the component carrier structure 102 (optionally still connected within body 160) along various portions between the inlet 106 and an outlet 108 of the apparatus 100. In particular, the handling unit 104 is configured for gripping and transferring the component carrier structure 102 to be tested (or the entire body 160) from the inlet accommodation unit 136 through the inlet 106 to a below described identification unit 110. More specifically, the handling unit 104 comprises an inlet handling subunit 122 configured for handling the component carrier structure 102 between the inlet 106 and a below described material removal unit 112. Advantageously, the handling unit 104 comprises one or more robots 120 which may comprise one or more hexapods, one or more linear robots, one or more articulated arm robots, etc. A six-axis robot or hexapod (schematically illustrated in Figure 2 at reference sign 120) may have axes equipped with sensors and being appropriate for handling component carrier structures 102 within fully automated apparatus 100. Advantageously, a hexapod may be used for a material removal process (in particular a grinding process) carried out by material removal unit 112, as such a hexapod can be mechanically stable and at the same time can be adapted very precisely in six axes. Referring to Figure 3, a six-axis robot or hexapod may be used in cross-sectional station 127 for operating material removal unit 112 and/or for operating alignment unit 154. Consequently, preparation of the component carrier structure 102 by material removal may become highly precise and robust against possible misalignments. Furthermore, a linear robot and/or an articulated arm robot (not shown) of inlet handling subunit 122 and/or at outlet handling subunit 124 of handling unit 104 can be used for handling component carrier structures 102 between the individual workstations of the automated apparatus 100.

As already mentioned, the inlet handling subunit 122 of the handling unit 104 forwards the component carrier structure 102 to the identification unit 110. The latter is configured for identifying the component carrier structure 102 for which the quality test shall be carried out. This may ensure traceability. More specifically, the identification unit 110 is configured for identifying the component carrier structure 102 based on the detection of an identifier 126 which may be physically connected to or which may form an integral part of the component carrier structure 102. For instance, such an identifier 126 may be a QR code, a barcode or an alphanumeric to code which can be read out by an optical reader of the identification unit 110. It is also possible that the identifier 126 is a transponder such as an RFID (radiofrequency identification) tag or an NFC (near field communication) tag. In such embodiments, the identification unit 110 may comprise a wireless reader configured for wirelessly reading out the transponder-type identifier 126 for retrieving identification information. For identifying the component carrier structure 102 based on its identifier 126 and/or for retrieving additional data (for instance specific quality test instructions) assigned to the identified component carrier structure 102, the identification unit 110 may access a corresponding database 128. In particular, the identification unit 110 may be configured for identifying the component carrier structure 102 by matching the detected identifier 126 with correlated identity information which is stored in an assigned data set in said database 128. For instance, such a data set may correlate an identification code readable from the identifier 126 with further information concerning the component carrier structure 102, for instance information concerning its manufacturing history (such as lot number, manufacturing date, manufacturing time, etc.). The identification unit 110 may also be configured for retrieving from the database 128 quality test related information indicative of the quality test to be carried out for the identified component carrier structure 102. Such quality test related information may define a quality test which shall be carried out for the identified component carrier structure 102. Different quality tests may be carried out for different types of component carrier structures 102.

In an embodiment in which the component carrier structure 102 has not yet been separated from the larger body 160 before introducing the component carrier structure 102 through inlet 106 into the apparatus 100, a singularization unit 148 (such as a milling machine or a laser cutter) may be provided and may be configured for singularizing the component carrier structure 102 from the panel-type body 160. For instance, singularization may be accomplished by milling or laser cutting.

Thereafter, the processed component carrier structure 102 may be conveyed by the handling unit 102 to a thermal stress exposing unit 150 configured for exposing the component carrier structure 102 to thermal stress. Preferably, the thermal stress exposing unit 150 is configured for floating the component carrier structure 102 on a thermal stress bath, which may comprise molten solder. Thereby, thermal stress may be subjected to the component carrier structure 100.

The component carrier structure 102 may then be forwarded by the above-mentioned or by another robot 120 of the handling unit 104 to a material removal unit 112. The latter is configured for removing material of the component carrier structure 102 for exposing an interior of the component carrier structure 102 undergoing or subjected to the quality test. In particular, the material removal unit 112 may be configured for removing material of the component carrier structure 102 by grinding, preferably cross-sectional grinding (or alternatively flat grinding).

For improving the precision of the material removal, the component carrier structure 102 may be aligned by an alignment unit 154 which may for instance be configured for determining an alignment marker (for instance a drill hole) of the component carrier structure 102 based on a captured image thereof). Said alignment may be carried out prior to grinding by material removal unit 112. Alignment unit 154 is assigned to the material removal unit 112 and may be configured for aligning the component carrier structure 102 before the material removal process. Hence, an alignment carried out by alignment unit 154 is preferably carried out before the material removal process executed by material removal unit 112. Such an alignment may thus form part of the material removal process, in particular grinding process.

Optionally, a removed material quantification unit 142 may be provided and configured for quantifying an amount of material removed from the component carrier structure 102 during grinding. By determining the amount of ground material, a grinding progress and hence a precise control of the grinding process may be made possible.

After grinding, the component carrier structure 102 may be supplied to a polishing unit 140 configured for polishing an exposed surface of the component carrier structure 102 after removing material. Rather than removing an additional substantial amount of material from the component carrier structure 102 (which occurs during grinding), polishing may reduce surface roughness and may improve surface quality without excessive material removal. A polished surface may provide more or more precise information concerning one or more tests targets 116 used as target features to be analysed in the following.

Only optionally, the component carrier structure 100 may then (or alternatively already before material removal by material removal unit 112) be supplied to an encapsulation unit 144 configured for encapsulating the component carrier structure 102 in an encapsulant 146 so that the component carrier structure 102 is to be detected subsequently in the encapsulant 146. Such encapsulant 146 may be a resin functioning as a stress buffer and simplifying handling of the component carrier structure 102 during a subsequent (and/or during a previous) analysis.

However, it may be alternatively possible and even preferred that such an encapsulation is omitted, since the fully automated quality test apparatus 100 may also be capable of carrying out the quality test of the component carrier structure 102 without encapsulation. Thus, even a non-encapsulated component carrier structure 102 may be subjected to the subsequent processes.

Thereafter, the (encapsulated or non-encapsulated) component carrier structure 102 may be forwarded, for instance by a further robot 120 of the handling unit 104, to a cleaning unit 152 configured for cleaning the component carrier structure 102. For instance, the component carrier structure 102 may be rinsed in an ultrasonic bath.

A further alignment unit 154 may be configured for aligning the component carrier structure 102 before detecting and determining tests targets 116 thereon. For this purpose, one or more alignment features (such as through holes, for instance arranged in corners) of the component carrier structure 102 may be detected and used for spatially aligning the component carrier structure 102.

The aligned component carrier structure 102 may then be imaged. For this purpose, a detection unit 162 may be provided and configured for detecting image data of a (meanwhile exposed by said material removal) interior of the component carrier structure 102.

Such image data may be transmitted to a determining unit 114. The latter may be configured for determining one or more pre-defined test target 116 of the component carrier structure 102. The test targets 116 may be predefined features visible in the imaged cross-section of the component carrier structure 102 and may relate to specifically meaningful features in terms of quality evaluation. Appropriate characteristics or attributes of test targets 116 of the component carrier structure 102 may be a diameter D of a drill hole 158 (in particular a laser drill hole or a mechanically drilled hole, which may be filled by plated copper), a distance L between such adjacent drill holes 158, a thickness d of an electrically conductive layer structure 130 (such as a patterned copper layer) and/or of an electrically insulating layer structure 132 (such as a sheet of prepreg), a planarity of a such a layer structure 130 and/or 132, and a degree of delamination (see reference sign 133) of such a layer structure 130 and/or 132. The mentioned test targets 116 are illustrated in Figure 2 in a top view 165 and in a side view 167, respectively. However, another test target 116 (for instance in the scenario of flat grinding) may be a copper line or a plurality of copper lines and a space in between.

Advantageously, the determining unit 114 is configured for processing the image data for determining or recognizing the pre-defined test targets 116. More specifically, the determining unit 114 may be configured for firstly determining the pre-defined test targets 116 in a coarse manner based on a detected first image of the component carrier structure 102. Moreover, the determining unit 114 may be configured for secondly determining the pre-defined test targets 116 in a refined manner based on a detected second image of the component carrier structure 102 detected after detecting the first image and after etching a surface of the component carrier structure 102. In an alternative embodiment, a one-shot operation of the determining unit 114 may be possible as well, in which the determining unit 114 determines test targets 116 based on a single image. As a basis for the determination, the determination unit 114 may also have access to database 128, for instance to get access to test targets 116 to be considered for the determination.

Highly advantageously and as indicated by a feedback loop 169, the determining unit 114 may be configured for determining the pre-defined test target(s) 116 by iteratively repeating a sequence comprising material removal (optionally including polishing and/or cleaning and/or etching), image detection, and image analysis. By such an iterative approach (which can be terminated when a sufficient accuracy is achieved), the reliability of the quality test may be significantly improved.

As further shown in Figure 2, an evaluation unit 118 is provided which is configured for evaluating the determined test target(s) 116 of the component carrier structure 102 for assessing the quality of the component carrier structure 102. The evaluation unit 118 may be advantageously configured for evaluating a quality of the component carrier structure 102 based on properties of the determined test target(s) 116. More specifically, the evaluation unit 118 may be configured for evaluating the quality by classifying the component carrier structure 102 into one of a plurality of quality classes. Highly appropriate may be an automated classification of a respective component carrier structure 102 (and/or an assigned larger body 160) in one class of a group of classes consisting of "pass" (indicating that the component carrier structure 102 and/or the larger body 160 has/have passed the quality test), "fail" (indicating that the component carrier structure 102 and/or the larger body 160 has/have not passed the quality test), and "further analysis required" (indicating that the component carrier structure 102 and/or the larger body 160 need additional quality analysis, since the evaluation unit 118 is not yet in a position to decide in a meaningful way about the quality). In the latter case, it may also be possible to convey the component carrier structure 102 to a human operator for human analysis. The described communication and user impact can be exchanged between the user and the apparatus 100 by an input/output unit 135 being communicatively coupled with control unit or processor 156.

In particular, the evaluation unit 118 may be configured for evaluating the quality by classifying each test target 116 individually or preferably each attribute or characteristic of each test target 116 of the component carrier structure 102 individually into one of a plurality of quality classes, in particular in one class of a group of classes consisting of "pass", "fail", and "further analysis required". Only slight deviations of uncritical parameters may still allow to classify a component carrier structure 102 as "pass". A defect may be classified as critical or uncritical based on a type of a specific defect and/or based on the intensity of a specific defect. Such a quality test may comprise multiple criteria, which may be judged individually to enable fine-gained decisions on quality and performance.

For supporting its evaluation tasks, the evaluation unit 118 may comprise an artificial intelligence module 134 configured for carrying out the evaluation using artificial intelligence, for instance making use of a neural network. Training data, etc., for training the artificial intelligence module 134 may also be stored in database 128.

By an optional etching process of etching the exposed surface of the component carrier structure 102, additional features on the analysed exposed surface of the component carrier structure 102, such as grain boundaries and plating lines, may become visible. This may render the evaluation of the characteristics of the test targets 116 by the evaluation unit 118 even more accurate.

After said evaluation, the analysed component carrier structure 102 may be transported out of the apparatus 100. For this purpose, the handling unit 104 is provided with an outlet handling subunit 124 configured for handling the component carrier structure 102 by means of at least one additional robot 120, for instance between the material removal unit 112 and the outlet 108. As shown, the apparatus 100 comprises an outlet accommodation unit 138 (for instance also of a magazine-type) arranged at the outlet 108 and configured for accommodating a plurality of component carrier structures 102 in a stacked fashion after testing. The handling unit 104 may be configured for transferring a tested component carrier structure 102 through the outlet 108 to the outlet accommodation unit 138. This may be accomplished for example by further robot 120.

As indicated with reference sign 156, the apparatus 100 may comprise one or more processors or a part of a processor which may be considered as a control unit for controlling operation of the apparatus 100 and its above-described constituents during the quality test of the component carrier structure 102.

Highly advantageously, the apparatus 100 may be configured for carrying out the quality test without human intervention between the inlet 106 and the outlet 108. Only optionally, a user access may be possible via input/output unit 135. The automated character of the apparatus 100 may accelerate the quality test and may render the quality test more accurate while reducing human resources required in terms of quality testing. Furthermore, the throughput may be increased.

**Figure 3** illustrates details of an apparatus 100 for carrying out a quality test of a component carrier structure 102 according to an exemplary embodiment of the invention. Figure 3 illustrates a specific embodiment showing elements of the apparatus 100 of Figure 2.

An input section 125 relates to a portion of the apparatus 100 between inlet 106 and material removal. A cross-sectioning station 127 corresponds so a subsequent portion of the apparatus 100 at which a cross-section of the component carrier structure 102 is created in a fully automated way by grinding and subsequently polishing. An output section 129 relates to a portion of the apparatus 100 between cross-sectioning station 127 and outlet 108.

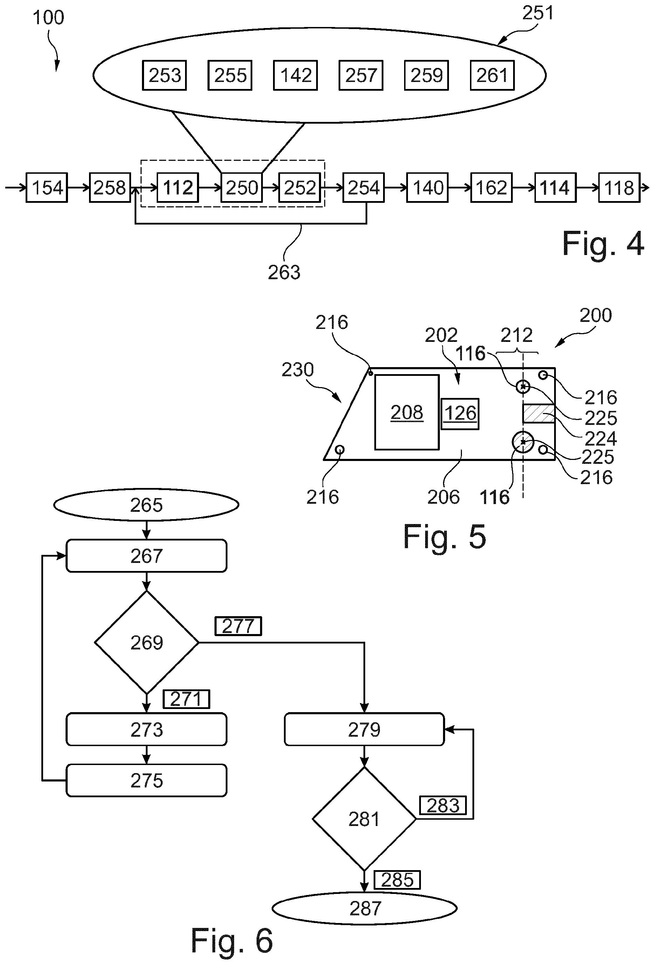

**Figure 4** illustrates an apparatus 100 for processing a component carrier structure 102 for a quality test according to an exemplary embodiment of the invention. More specifically, Figure 4 shows only part of such an apparatus 100, wherein further elements of the apparatus of Figure 2 may also be combined with the elements shown in Figure 4. Figure 4 focuses on processes in terms of the material removal from the component carrier structure 102 for exposing one or more test targets 116 in accordance with a predefined material removal objective.

When a component carrier structure (such as the one shown with reference sign 102 in Figure 2 being embodied for instance as a coupon) has been inserted into apparatus 100 via an inlet (see reference sign 106 in Figure 2), the component carrier structure 102 may - for instance after being pre-processed as described referring to Figure 2 - be forwarded to an alignment unit 154 (shown in Figure 4) configured for aligning the component carrier structure 102 before the material removal. For this purpose, the component carrier structure 102 may be provided with alignment structures, such as through holes in corners of the component carrier structure 102 (see reference sign 216 in Figure 5).

Before, during and/or after alignment, an initial measuring unit 258 may be used for measuring the component carrier structure 102 initially, i.e. before the removal of material. Initial measuring unit 258 may for instance be a camera capturing an image of the component carrier structure 102. Information such as position, orientation and/or structural artefacts of the component carrier structure 102 may be identified by initial measuring unit 258. In accordance with such data captured by initial measuring unit 258, a subsequent material removal process may be adjusted and/or a position and/or an orientation of the component carrier structure 102 may be corrected.

Thereafter, the component carrier structure 102 proceeds to a material removal unit 112. The latter may be configured for removing material of the component carrier structure 102 for exposing one or more test targets 116 in an interior of the component carrier structure 102 to be subjected to the quality test. For instance, the material removal unit 112 removes material of the component carrier structure 102 by grinding, preferably by cross-sectional grinding. Advantageously, the material removal unit 112 may be configured for removing material of the component carrier structure 102 by a coarse grinding stage using a larger grain size followed by a fine grinding stage using a smaller grain size. This may allow to smoothly handle the sensitive component carrier structure 102 and may prevent quality issues from being introduced into the component carrier structure 102 due to its treatment during the material removal.

As shown in Figure 4 as well, a progress measuring unit 250 may be provided in the apparatus 100 and may be configured for measuring a progress of the removal of material of the component carrier structure 102 preferably during (and/or after) the removal of material. Various embodiments of the progress measuring unit 250 will be described below referring to Figure 5, and Figure 7 to Figure 10. As shown schematically by reference sign 251, the progress measuring unit 250 may comprise one of, any desired combination of two or more of, or all of the following elements: an optical progress measurement 253 using a camera for capturing an image of component carrier structure 102; an electric progress measurement 255 for carrying out an electric measurement on a test target 116 or a sacrificial structure 224; a removed material quantification unit 142; a measurement of a spatial advancing 257 of a material removal unit 112; a detection 259 of contact pressure at material removal unit 112; and a detection 261 of rotation speed at material removal unit 112. The aforementioned reference signs relate to Figure 5, and Figure 7 to Figure 10.

After measuring the progress of the material removal process by progress measuring unit 250, an analysis unit 252 of the apparatus 100 analyses whether the measured progress meets requirements of a predefined material removal objective. For instance, it may be analysed whether a center 225 of a test target 116 is visible in a cross-sectional plane of the component carrier structure 102 exposed by the material removal.

A control unit 254 (which may also be integrated into processor 156 shown in Figure 2) is provided for controlling the further processes based on a result of the analysis. When the material removal objective is not yet achieved, the control unit 254 controls handling of the component carrier 102 so that the sequence of removing material by material removal unit 112, measuring a progress thereof by progress measuring unit 250, and analyzing - by analysis unit 252 - whether the measured progress meets the mentioned requirements until the predefined material removal objective is achieved, is repeated once or multiple times. In this context, the control unit 254 may operate the component carrier structure 102 for iteratively repeating the sequence by handling it along a regulating loop 263.

When the predefined material removal objective is achieved, the component carrier structure 102 is forwarded to a polishing unit 140 for polishing an exposed surface of the component carrier structure 102 after removing material. By polishing, the surface - exposed by the material removal - of the component carrier structure 102 may be planarized, and its roughness may be reduced. This may improve the accuracy of the quality test since attributes of one or more test targets 116 are better visible on a captured image of the cross-section.

After detecting an image of the now exposed, polished and preferably cleaned surface of the component carrier structure 102 by a detection unit 162, corresponding image data may be supplied to a determining unit 114 configured for determining on said image the at least one test target 116 of the component carrier structure 102. An evaluation unit 118 may than evaluate a characteristic or an attribute of the determined at least one test target 116 of the component carrier structure 102 for assessing the quality of the component carrier structure 102.

Advantageously, the described apparatus 100 is configured for carrying out the quality test without human intervention. As a result, a highly accurate quality test may be carried out with a high throughput.

**Figure 5** illustrates a coupon 200 as an example for a component carrier structure 102 and comprising a sacrificial structure 224 used for progress control of a material removal process according to an exemplary embodiment of the invention.

Coupon 200 comprises a PCB-type base plate 202 having a handling area 208 for robotic handling of the coupon 200 by handling unit 104. An identifier 126, such as a QR code, allows identification of the coupon 200. A plurality of test targets 116, here embodied as copper filled drill holes, are located in a test area 212 being positioned apart from handling area 208. According to Figure 5, base plate 202 of the coupon 200 is provided with a mechanical coding feature 230 as mechanical code ensuring proper orientation of the coupon 200 when inserted into apparatus 100. In the shown embodiment, the mechanical coding feature 230 is embodied as a slanted edge of the - apart from this - substantially rectangular base plate 202.

Furthermore, the coupon 200 of Figure 5 comprises a plurality of alignment structures 216 which are here embodied as alignment through holes. Said alignment structures 216 are arranged in corner regions/corners of the base plate 202. The copper free alignment structures 216, being realized as reference through holes extending entirely through base plate 202, enable alignment by an optical camera of apparatus 100. Such an alignment may be advantageous during material removal and/or during polishing and/or image detection.

Moreover, coupon 200 of Figure 5 comprises an electrically conductive sacrificial structure 224 which may for instance be embodied as a metal insert in base plate 202. Sacrificial structure 224 may be used for progress control of a material removal unit 112 such as a grinding tool during grinding coupon 200. For this purpose, electrodes (not shown) of apparatus 100 may be connected with electrically conductive sacrificial structure 224 during material removal from the right hand side of Figure 5. At the beginning, the electrodes can measure an electric signal at electrically conductive sacrificial structure 224. When sacrificial structure 224 is removed during the material removal, the electric signal changes and finally vanishes when sacrificial structure 224 is entirely removed. This event corresponds to a scenario in which the material removal has exposed centers 225 of metal filled through holes constituting test targets 116. Thus, loss of the electric signal detected at sacrificial structure 224 may be used as a trigger to switch off material removal unit 112, since a desired target position (corresponding to the predefined material removal objective) concerning the cross-sectional view of the test targets 116 has been reached. Hence, sacrificial structure 222 may be intentionally removed during removing material of the coupon 200 for exposing the test targets 116. Consequently, sacrificial structure 224 can be used for detecting a progress of the material removal up to a target exposure of the test targets 116, since the sacrificial structure 224 is arranged so that it is fully removed during removing material of the coupon 200 when the centers 225 of the test holes 220 are reached. Alternatively, measuring the remaining resistance of the sacrificial structure 222 during material removal may also be used as a basis for progress control.

In an embodiment, the sacrificial structure 224 is structured in a way to indicate different portions needed for process control. For example, a first portion (e.g. 90%) may be defined where a first grinding material can be used, a second portion (e.g. 7.5%) may be defined where a second grinding material (which may be a finer material than the first material) is used, and a third portion (e.g. the last 2.5%) may be defined where a third material can be used for fine-grinding or polishing the remaining section.

**Figure 6** illustrates a block diagram of a method of processing a component carrier structure 102 for a quality test according to an exemplary embodiment of the invention.

The method may be started in a block 265. A target position measurement concerning the component carrier structure 102 may then be carried out in block 267. It is then assessed whether the target position has been reached, see block 269. If no (see block 271), sample alignment is carried out in a block 273 followed by a target preparation process 275. The process may then be continued in block 267. If yes (see block 277), the component carrier structure 102 is polished, compare block 279. It is then assessed whether the surface quality is acceptable, see block 281. If no (see block 283), polishing is repeated. If yes (see block 285), the process ends in block 287.

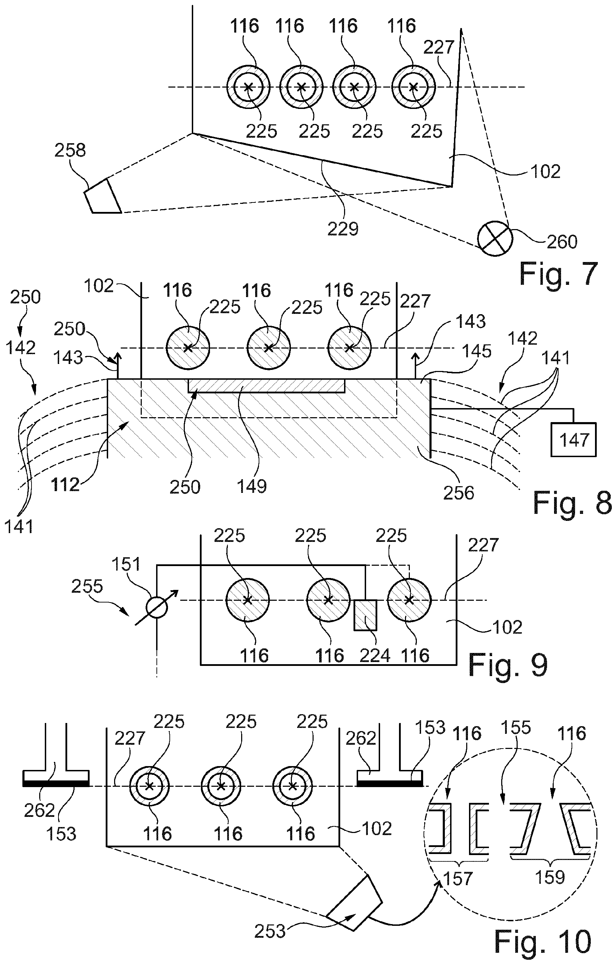

**Figure 7** illustrates a component carrier structure 102 with test targets 116 prior to a material removal process and being initially and/or continuously monitored for adjusting a material removal process according to an exemplary embodiment of the invention.

The illustrated component carrier structure 102 can for instance be a printed circuit board (PCB) with copper plated drill holes as tests targets 116. Said test targets 116 are arranged with their centers 225 along a straight line 227 and extend into the paper plane of Figure 7. As shown, the component carrier structure 102 has a slanted front edge 229 which is to be subjected to a material removal process by grinding.

Before removing material from the component carrier structure 102, an initial measuring unit 258 may be used for measuring the component carrier structure 102. In the shown embodiment, initial measuring unit 258 is embodied as an optical camera. When capturing an image of the component carrier structure 102 shown in Figure 7, initial measuring unit 258 can identify the slanted front edge 229 of the component carrier structure 102. The material removal process carried out by the material removal unit 112 may then be adjusted for removing material of the component carrier structure 102 under consideration of a measuring result of the initial measuring unit 258. In the shown example, the material removal process may be carried out so that front edge 229 of the processed component carrier structure 110 extends horizontally after grinding.

Furthermore, Figure 7 shows a monitoring unit 260 which is here embodied as an X-ray camera. The illustrated X-ray camera is configured for once, regularly or even continuously monitoring the component carrier structure 102 before, during and/or after removing material from the component carrier structure 102. In particular, monitoring unit 260 may also detect the copper-type test targets 116 in an interior of the resin matrix of component carrier structure 102. Based on this information, the material removal process may be adjusted correspondingly. Also a progress of the material removal process may be detected by X-ray camera-type monitoring unit 260. During removing material (in particular by grinding), also the copper-type test targets 116 are continuously removed, which can be detected by monitoring unit 260. Based on X-ray images captured by monitoring unit 260, the material removal process can be controlled to stop precisely when a predefined material removal objective is achieved. In the shown embodiment, said predefined material removal objective is achieved when material removal has been carried out up to straight line 227 so that the centers 225 of the test targets 116 are exposed.

**Figure 8** illustrates a component carrier structure 102 with test targets 116 subjected to a material removal process by a material removal unit 112, wherein an advancing of the material removal unit 112 and/or an amount of removed material may be monitored for progress control according to an exemplary embodiment of the invention.

The illustrated component carrier structure 102 can for instance be a PCB with fully copper filled drill holes as test targets 116 arranged with their centers 225 along straight line 227, which defines again the predefined material removal objective at which the material removal process shall stop. Again, this may be ensured by progress measuring unit 250. In the shown embodiment, progress measuring unit 250 may use multiple sensed parameters in combination to determine and control progress of material removal unit 112 up to, but not beyond straight line 227. Alternatively, progress measuring unit 250 may use only one of the measures mentioned in the following.

As shown, progress measuring unit 250 comprises a schematically illustrated removed material quantification unit 142 being configured for quantifying an amount of material removed from the component carrier structure 102 by the material removal unit 112. The material removal unit 112 is here embodied as a grinding device which removes material from component carrier structure 102 by grinding. Said removed material (more specifically grinding chips) is shown with reference sign 141 in Figure 8. Although not shown in Figure 8, the progress measuring unit 250 may comprise a weighing device determining a weight and thus amount of the removed material. When the properties of the component carrier structure 102 are known, it may be determined which amount of material shall be removed for exposing the test targets 116 at straight line 227.

In addition to or alternatively to removed material quantification unit 142, progress measuring unit 250 may comprise a removed material analysis unit being configured for analyzing (for instance chemically analyzing) material removed from the component carrier structure 102 by the material removal unit 112. For instance, such an analysis may distinguish a time interval during which resin material is removed from the component carrier structure 102 and another time interval during which also copper material is removed from the component carrier structure 102. By such an analysis, the progress of the material removal may be determined, when the construction of the component carrier structure 102 is known.

In order to further improve the resolution of the determination of the progress of the material removal, the progress measuring unit 250 may also measure a spatial advancing of the material removal unit 112 during removing material of the component carrier structure 102. This spatial advancing is denoted schematically by arrows 143. As shown, grinding tool 145 of material removal unit 102 may be driven by a drive unit 147 such as an electric motor. By sensing the motion triggered by drive unit 147 for driving grinding tool 145, the spatial advancing of grinding tool 145 in a vertical direction according to Figure 8 and into the component carrier structure 102 may be detected. Also this detection may provide information usable for stopping the material removal process at straight line 227, i.e. in accordance with a predetermined material removal objective.

Furthermore, the progress measuring unit 250 may be configured for measuring the progress based on a detection of a contact pressure of the material removal unit 112 against the component carrier structure 102 during removing material of the component carrier structure 102. For this purpose, the material removal unit 112 may be provided with a pressure sensor 149, preferably close to a front side of grinding device 145. When the grinding device 145 is moved forward against the component carrier structure 102, a contact pressure in between may be detected by pressure sensor 149. While the grinding device 145 removes relatively soft resin material from component carrier structure 102, the measured contact pressure may be small. When the grinding device 105 reaches harder copper material of tests targets 116 and starts removing them partially, the detected contact pressure will be increased. It may become maximum when the straight line 227 with a maximum copper cross-section is reached. Hence, also the time dependence of the contact pressure may be used for progress determination and control. Additionally or alternatively to contact pressure, it is also possible to measure the progress based on a rotation speed of a rotatable body 256 of the material removal unit 112 during removing material of the component carrier structure 102.

**Figure 9** illustrates a component carrier structure 102 with test targets 116 and a sacrificial structure 224 subjected to a material removal process by a material removal unit 112, wherein an electric signal may be detected at the sacrificial structure 224 and/or a test target 116 for progress control according to an exemplary embodiment of the invention.

The progress measuring unit 250 according to Figure 9 is configured for measuring the progress of the material removal unit 112 by electrically measuring an electrically conductive structure in form of a test target 116 and/or a sacrificial structure 224 of the component carrier structure 102. The test targets 116 are again embodied as fully copper filled drill holes, as in Figure 8. The sacrificial structure 224 is also made of copper, and functions in a similar way as sacrificial structure 224 in Figure 5. The centers 225 of the tests targets 116 as well as a backside of the sacrificial structure 224 are arranged along straight line 227 defining the predefined material removal objective at which the material removal process shall stop.

As shown, the progress measuring unit 250 comprises an electric detection unit 151 (for instance capable of measuring voltage or electric current) which is electrically coupled with the sacrificial structure 224 and/or one or more of the test targets 116. During material removal from component carrier structure 102 by material removal unit 112 starting from a bottom side of Figure 9, the material removal unit 112 will, at a certain point of time, reach sacrificial structure 224 and will start removing it. Consequently, the ohmic resistance of the remaining copper material of ground sacrificial structure 224 will be increased, which can be detected by electric detection unit 151. At the point of time of completely removing the sacrificial structure 224, i.e. when straight line 227 corresponding to predefined material removal objective is reached, the electric signal originating from sacrificial structure 224 will vanish, which can be used as a trigger for stopping the material removal process.

Additionally or alternatively to capturing an electric signal at sacrificial structure 224, it is also possible to carry out such a measurement on one or more of the tests targets 116, also made of electrically conductive copper. When the material removal process reaches the bottom sided end of test targets 116, the ohmic resistance of the test targets 116 starts to increase, which can be detected by electric detection unit 151. When the straight line 227 is reached, half of the material of the tests targets 116 is removed. This event can be detected, since the ohmic resistance and therefore the electric signal detected by electric detection 151 has a characteristic value in this scenario. The material removal process can then be terminated. It is also possible to detect the event that straight line 227 has been reached by analyzing the gradient of the electric signal, since reaching straight line 227 corresponds to a turning point of said gradient.

**Figure 10** illustrates a component carrier structure 102 with test targets 116 and a mechanical stopper 262 for disabling an excessive material removal in terms of progress control according to an exemplary embodiment of the invention.

The shown mechanical stopper 262 can be placed at a position so that it is configured for abutting against the component carrier structure 102 for disabling an excessive material removal of the component carrier structure 102 by the material removal unit 112. In other words, when the material removal unit 110 has reached straight line 227 corresponding to the predefined material removal objective, the material removal unit 112 will abut against a preferably hardened abutment surface 153 of the mechanical stopper 262.

As shown in Figure 10, it is also possible that the progress measuring unit 250 is configured for measuring the progress by optically detecting one or more images of the component carrier structure 102, as illustrated schematically in Figure 10 with reference sign 155. On such an image, a cross-section of a respective test target 116 is visible, here embodied as copper plated through hole. In a first scenario shown with reference sign 157, the exposed plane of component carrier structure 102 shows straight walls of circular cylindrical test target 116, which indicates a properly vertical (for instance "properly" according to one or more evaluation criteria which may be stored in a database) cross-sectional side wall. The component carrier structure 102 may thus proceed to determination and evaluation of quality. In a second scenario shown with reference sign 159, the exposed plane of component carrier structure 102 shows slanted side walls of circular cylindrical test target 116, which indicates an improperly (for instance "improperly" according to one or more evaluation criteria which may be stored in a database) slanted cross-sectional side wall of component carrier structure 102. A correction by an additional material removal might then be triggered.

It should be noted that the term "comprising" does not exclude other elements or steps.

It should also be noted that reference signs in the claims shall not be construed as limiting the scope of the claims.

Implementation of the invention is not limited to the preferred embodiments shown in the figures and described above. Instead, a multiplicity of variants is possible which use the solutions shown and the principle according to the invention, whose scope is defined by the appended claims.

## Claims

1. Apparatus (100) for processing a component carrier structure (102) for a quality test, wherein the apparatus (100) comprises:
a material removal unit (112) configured for removing material of the component carrier structure (102) for exposing at least one test target (116) in an interior of the component carrier structure (102) to be subjected to the quality test;
a progress measuring unit (250) configured for measuring a progress of the removal of material of the component carrier structure (102);
an analysis unit (252) configured for analyzing whether the measured progress meets requirements of a predefined material removal objective; and
a control unit (254) configured for controlling, based on a result of the analysis, whether or not the sequence of removing material, measuring a progress thereof, and analyzing whether the measured progress meets the requirements of the predefined material removal objective has to be repeated,
**characterised in that** the apparatus (100) further comprises:
a determining unit (114) configured for determining the at least one test target (116) of the component carrier structure (102) after said material removal; and
an evaluation unit (118) configured for evaluating a characteristic of the determined at least one test target (116) of the component carrier structure (102) for assessing the quality of the component carrier structure (102).

2. The apparatus (100) according to claim 1, comprising at least one of the following features:
wherein the control unit (254) is configured for iteratively repeating once or a plurality of times the sequence of removing material, measuring a progress thereof, and analyzing whether the measured progress meets the requirements until the predefined material removal objective is achieved;
wherein the control unit (254) is configured for iteratively repeating the sequence in a regulating loop.

3. The apparatus (100) according to any of claims 1 to 2, wherein the material removal unit (112) is configured for removing material of the component carrier structure (102) by grinding.

4. The apparatus (100) according to claim 3, comprising at least one of the following features:
wherein the material removal unit (112) is configured for removing material of the component carrier structure (102) by one of the group consisting of cross-sectional grinding and flat grinding;
wherein the material removal unit (112) is configured for removing material of the component carrier structure (102) by a coarse grinding stage followed by a fine grinding stage.

5. The apparatus (100) according to any of claims 1 to 4, comprising at least one of the following features:
comprising a polishing unit (140) for polishing an exposed surface of the component carrier structure (102) after removing material;
wherein the progress measuring unit (250) is configured for measuring the progress during the removal of material by the material removal unit (112);
wherein the progress measuring unit (250) is configured for measuring the progress by optically detecting an image of the component carrier structure (102).

6. The apparatus (100) according to any of claims 1 to 5, wherein the progress measuring unit (250) is configured for measuring the progress by electrically measuring an electric signal at an electrically conductive structure (116, 224) of the component carrier structure (102).

7. The apparatus (100) according to claim 6, comprising at least one of the following features:
wherein the electrically conductive structure (116, 224) belongs to one of the group consisting of a test target (116) and a sacrificial structure (224) of the component carrier structure (102);
wherein the progress measuring unit (250) is configured for measuring the progress by detecting an electric signal of the electrically conductive structure (116, 224) to be at least partially removed during the material removal for exposing the at least one test target (116), wherein the electrically conductive structure (116, 224) is configured to be used for detecting a progress of the material removal up to an exposure of the at least one test target (116) in accordance with the predefined material removal objective.

8. The apparatus (100) according to any of claims 1 to 7, comprising at least one of the following features:
wherein the progress measuring unit (250) comprises a removed material quantification unit (142) configured for quantifying an amount of material removed from the component carrier structure (102) by the material removal unit (112);
wherein the progress measuring unit (250) is configured for measuring the progress based on a spatial advancing of the material removal unit (112) during removing material of the component carrier structure (102);
wherein the progress measuring unit (250) is configured for measuring the progress based on a detection of a contact pressure of the material removal unit (112) against the component carrier structure (102) during removing material of the component carrier structure (102);
wherein the progress measuring unit (250) is configured for measuring the progress based on a detection of a rotation speed of a rotatable body of the material removal unit (112) during removing material of the component carrier structure (102).

9. The apparatus (100) according to any of claims 1 to 8,
comprising an initial measuring unit (258) configured for measuring the component carrier structure (102) initially before the removal of material;
wherein the material removal unit (112) is configured for removing material of the component carrier structure (102) based on a measuring result of the initial measuring unit (258).

10. The apparatus (100) according to any of claims 1 to 9, comprising at least one of the following features:
wherein the at least one test target (116) of the component carrier structure (102) comprises at least one of the group consisting of at least one drill hole (158), and at least one layer structure (130, 132);
wherein a characteristic of the at least one test target (116) of the component carrier structure (102) to be evaluated during the quality test comprises at least one of the group consisting of a diameter (D) of a drill hole (158), a distance (L) between adjacent drill holes (158), a width of an electrically conductive trace of an electrically conductive layer structure (130), a distance between adjacent electrically conductive traces of an electrically conductive layer structure (130), a thickness (d) of a layer structure (130, 132), a planarity of a layer structure (130, 132), delamination of a layer structure (130, 132), and any feature of a printed circuit board-type component carrier structure (102);
comprising a monitoring unit (260), in particular an X-ray device, configured for monitoring, in particular for continuously monitoring, the component carrier structure (102) at least during at least part of said sequence;
wherein the material removal objective is to reach a center (225) of a test target (116), in particular of a drill hole or an electrically conductive structure, of the component carrier structure (102);
comprising a mechanical stopper (262) configured for abutting against the material removal unit (112) for disabling an excessive material removal of the component carrier structure (102) by the material removal unit (112);
wherein the apparatus (100) is configured for carrying out the quality test without human intervention;
comprising an alignment unit (154) configured for aligning the component carrier structure (102) before the material removal, in particular based on a detection of at least one alignment structure (216) of the component carrier structure (102).

11. A method of processing a component carrier structure (102) for a quality test, wherein the method comprises:
removing material of the component carrier structure (102) for exposing at least one test target (116) in an interior of the component carrier structure (102) to be subjected to the quality test;
measuring a progress of the removal of material of the component carrier structure (102);
analyzing whether the measured progress meets requirements of a predefined material removal objective; and
controlling, based on a result of the analyzing, whether or not the sequence of removing material, measuring a progress thereof, and analyzing whether the measured progress meets the requirements of the predefined material removal objective has to be repeated,
**characterised in that** the method further comprises:
determining, by a determining unit (114), the at least one test target (116) of the component carrier structure (102) after said material removal; and
evaluating, by an evaluation unit (118), a characteristic of the determined at least one test target (116) of the component carrier structure (102) for assessing the quality of the component carrier structure (102).

12. The method (100) according to claim 11, comprising at least one of the following features:
wherein the method comprises iteratively repeating once or a plurality of times the sequence of removing material, measuring a progress thereof, and analyzing whether the measured progress meets the requirements until the predefined material removal objective is achieved;
wherein the component carrier structure (102) comprises one of the group consisting of a panel comprising multiple connected preforms of component carriers, an array comprising multiple connected preforms of component carriers, a preform of a component carrier, a coupon, and a component carrier, in particular one of a printed circuit board and an integrated circuit substrate;
wherein the method comprises carrying out the quality test without human intervention.

13. A computer-readable medium, in which a computer program of processing a component carrier structure (102) for a quality test is stored, which computer program, when being executed by one or a plurality of processors (156), is adapted cause the apparatus of any of claims 1 to 10 to execute the steps of a method according to any of claims 11 or 12.

14. A program element of processing a component carrier structure (102) for a quality test, which program element, when being executed by one or a plurality of processors (156), is adapted to cause the apparatus of any of claims 1 to 10 to execute the steps of a method according to any of claims 11 or 12.

## Patentansprüche

1. Vorrichtung (100) zum Verarbeiten einer Komponententrägerstruktur (102) für einen Qualitätstest, wobei die Vorrichtung (100) aufweist:
eine Materialentfernungseinheit (112), welche zum Entfernen eines Materials der Komponententrägerstruktur (102) konfiguriert ist, zum Freilegen zumindest eines Testziels (116) in einem Inneren der Komponententrägerstruktur (102), welche dem Qualitätstest zu unterziehen ist;
eine Fortschrittsmesseinheit (250), welche zum Messen eines Fortschritts der Entfernung von Material der Komponententrägerstruktur (102) konfiguriert ist;
eine Analyseeinheit (252), welche zum Analysieren konfiguriert ist, ob der gemessene Fortschritt den Anforderungen eines vordefinierten Materialentfernungsziels entspricht; und
eine Steuereinheit (254), welche zum Steuern konfiguriert ist, basierend auf einem Ergebnis der Analyse, ob oder ob nicht die Sequenz des Entfernens von Material, das Messen eines Fortschritts davon, und das Analysieren, ob der gemessene Fortschritt den Anforderungen des vordefinierten Materialentfernungsziels entspricht, wiederholt werden muss,
**dadurch gekennzeichnet, dass** die Vorrichtung (100) ferner aufweist:
eine Bestimmungseinheit (114), welche zum Bestimmen des mindestens einen Testziels (116) der Komponententrägerstruktur (102) nach der Materialentfernung konfiguriert ist; und
eine Evaluierungseinheit (118), welche zum Evaluieren einer Eigenschaft des bestimmten mindestens einen Testziels (116) der Komponententrägerstruktur (102) konfiguriert ist, zum Bewerten der Qualität der Komponententrägerstruktur (102).

2. Die Vorrichtung (100) gemäß Anspruch 1, aufweisend mindestens eines der folgenden Merkmale:
wobei die Steuereinheit (254) zum iterativen Wiederholen, einmalig oder mehrere Male, der Sequenz des Entfernens von Material, des Messens eines Fortschritts davon, und des Analysierens konfiguriert ist, ob der gemessene Fortschritt den Anforderungen entspricht, bis das vordefinierte Materialentfernungsziel erreicht ist;
wobei die Steuereinheit (254) zum iterativen Wiederholen der Sequenz in einer Regelschleife konfiguriert ist.

3. Die Vorrichtung (100) gemäß einem beliebigen der Ansprüche 1 bis 2, wobei die Materialentfernungseinheit (112) zum Entfernen von Material der Komponententrägerstruktur (102) mittels Schleifens konfiguriert ist.

4. Die Vorrichtung (100) gemäß Anspruch 3, aufweisend mindestens eines der folgenden Merkmale:
wobei die Materialentfernungseinheit (112) zum Entfernen von Material der Komponententrägerstruktur (102) mittels einem aus der Gruppe konfiguriert ist, bestehend aus Querschnittsschleifen und flachem Schleifen;
wobei die Materialentfernungseinheit (112) zum Entfernen von Material der Komponententrägerstruktur (102) mittels einer Grobschleifstufe gefolgt von einer Feinschleifstufe konfiguriert ist.

5. Die Vorrichtung (100) gemäß einem beliebigen der Ansprüche 1 bis 4, aufweisend mindestens eines der folgenden Merkmale:
aufweisend eine Poliereinheit (140) zum Polieren einer freiliegenden Oberfläche der Komponententrägerstruktur (102) nach dem Entfernen von Material;
wobei die Fortschrittsmesseinheit (250) zum Messen des Fortschritts während der Entfernung von Material mittels der Materialentfernungseinheit (112) konfiguriert ist;
wobei die Fortschrittsmesseinheit (250) zum Messen des Fortschritts mittels optischen Detektierens eines Bilds der Komponententrägerstruktur (102) konfiguriert ist.

6. Die Vorrichtung (100) gemäß einem beliebigen der Ansprüche 1 bis 5, wobei die Fortschrittsmesseinheit (250) zum Messen des Fortschritts mittels elektrischen Messens eines elektrischen Signals an einer elektrisch leitfähigen Struktur (116, 224) der Komponententrägerstruktur (102) konfiguriert ist.

7. Die Vorrichtung (100) gemäß Anspruch 6, aufweisend mindestens eines der folgenden Merkmale:
wobei die elektrisch leitfähige Struktur (116, 224) zu einem aus der Gruppe gehört, bestehend aus einem Testziel (116) und einer Opferstruktur (224) der Komponententrägerstruktur (102);
wobei die Fortschrittsmesseinheit (250) zum Messen des Fortschritts mittels Detektierens eines elektrischen Signals der elektrisch leitfähigen Struktur (116, 224) konfiguriert ist, welche während der Materialentfernung zum Freilegen des mindestens einen Testziels (116) zumindest teilweise zu entfernen ist, wobei die elektrisch leitfähige Struktur (116, 224) konfiguriert ist, zum Detektieren eines Fortschritts der Materialentfernung verwendet zu werden, bis zu einem Freilegen des mindestens einen Testziels (116) in Übereinstimmung mit dem vordefinierten Materialentfernungsziel.

8. Die Vorrichtung (100) gemäß einem beliebigen der Ansprüche 1 bis 7, aufweisend mindestens eines der folgenden Merkmale:
wobei die Fortschrittsmesseinheit (250) eine Entferntes-Material-Quantifizierungseinheit (142) aufweist, welche zum Quantifizieren einer Menge von Material konfiguriert ist, welches von der Komponententrägerstruktur (102) mittels der Materialentfernungseinheit (112) entfernt wurde;
wobei die Fortschrittsmesseinheit (250) zum Messen des Fortschritts basierend auf einem räumlichen Fortschreiten der Materialentfernungseinheit (112) während des Entfernens von Material der Komponententrägerstruktur (102) konfiguriert ist;
wobei die Fortschrittsmesseinheit (250) zum Messen des Fortschritts basierend auf einer Detektion eines Kontaktdrucks der Materialentfernungseinheit (112) gegen die Komponententrägerstruktur (102) während des Entfernens von Material der Komponententrägerstruktur (102) konfiguriert ist;
wobei die Fortschrittsmesseinheit (250) zum Messen des Fortschritts basierend auf einer Detektion einer Rotationsgeschwindigkeit eines rotierbaren Körpers der Materialentfernungseinheit (112) während des Entfernens von Material der Komponententrägerstruktur (102) konfiguriert ist.

9. Die Vorrichtung (100) gemäß einem beliebigen der Ansprüche 1 bis 8,
aufweisend eine Anfangsmesseinheit (258), welche zum Messen der Komponententrägerstruktur (102) anfänglich vor der Entfernung von Material konfiguriert ist;
wobei die Materialentfernungseinheit (112) zum Entfernen von Material der Komponententrägerstruktur (102) basierend auf einem Messergebnis der Anfangsmesseinheit (258) konfiguriert ist.

10. Die Vorrichtung (100) gemäß einem beliebigen der Ansprüche 1 bis 9, aufweisend mindestens eines der folgenden Merkmale:
wobei das mindestens eine Testziel (116) der Komponententrägerstruktur (102) mindestens eines aus der Gruppe aufweist, bestehend aus mindestens einem Bohrloch (158) und mindestens einer Schichtstruktur (130, 132);
wobei eine Eigenschaft des mindestens einen Testziels (116) der Komponententrägerstruktur (102), welche während des Qualitätstests zu bewerten ist, mindestens eines aus der Gruppe aufweist, bestehend aus einem Durchmesser (D) eines Bohrlochs (158), einem Abstand (L) zwischen benachbarten Bohrlöchern (158), einer Breite einer elektrisch leitfähigen Bahn einer elektrisch leitfähigen Schichtstruktur (130), einem Abstand zwischen benachbarten elektrisch leitfähigen Bahnen einer elektrisch leitfähigen Schichtstruktur (130), einer Dicke (d) einer Schichtstruktur (130, 132), einer Ebenheit einer Schichtstruktur (130, 132), einer Delaminierung einer Schichtstruktur (130, 132), und einer beliebigen Eigenschaft einer gedruckten leiterplattenartigen Komponententrägerstruktur (102);
aufweisend eine Überwachungseinheit (260), insbesondere eine Röntgenvorrichtung, welche zum Überwachen, insbesondere zum kontinuierlichen Überwachen, der Komponententrägerstruktur (102) zumindest während zumindest eines Teils der Sequenz konfiguriert ist;
wobei das Materialentfernungsziel ist, eine Mitte (225) eines Testziels, (116), insbesondere eines Bohrlochs oder einer elektrisch leitfähigen Struktur, der Komponententrägerstruktur (102) zu erreichen;
aufweisend einen mechanischen Anschlag (262), welcher zum Anstoßen gegen die Materialentfernungseinheit (112) konfiguriert ist, zum Verunmöglichen einer übermäßigen Materialentfernung der Komponententrägerstruktur (102) mittels der Materialentfernungseinheit (112);
wobei die Vorrichtung (100) zum Ausführen des Qualitätstests ohne ein menschliches Eingreifen konfiguriert ist;
aufweisend eine Ausrichtungseinheit (154), welche zum Ausrichten der Komponententrägerstruktur (102) vor der Materialentfernung konfiguriert ist, insbesondere basierend auf einer Detektion mindestens einer Ausrichtungsstruktur (216) der Komponententrägerstruktur (102).

11. Ein Verfahren zum Verarbeiten einer Komponententrägerstruktur (102) für einen Qualitätstest, wobei das Verfahren aufweist:
Entfernen von Material der Komponententrägerstruktur (102) zum Freilegen mindestens eines Testziels (116) in einem Inneren der Komponententrägerstruktur (102), welche dem Qualitätstest zu unterziehen ist;
Messen eines Fortschritts der Entfernung von Material der Komponententrägerstruktur (102);
Analysieren, ob der gemessene Fortschritt den Anforderungen eines vordefinierten Materialentfernungsziel zu entspricht; und
Steuern, basierend auf einem Ergebnis des Analysierens, ob oder ob nicht die Sequenz des Entfernens von Material, des Messens eines Fortschritts davon, und des Analysierens, ob der gemessene Fortschritt den Anforderungen des vordefinierten Materialentfernungsziels entspricht, wiederholt werden muss,
**dadurch gekennzeichnet, dass** das Verfahren ferner aufweist:
Bestimmen, mittels einer Bestimmungseinheit (114), des mindestens einen Testziels (116) der Komponententrägerstruktur (102) nach der Materialentfernung; und
Evaluieren, mittels einer Evaluierungseinheit (118), einer Eigenschaft des bestimmten mindestens einen Testziels (116) der Komponententrägerstruktur (102) zum Bewerten der Qualität der Komponententrägerstruktur (102).

12. Das Verfahren (100) gemäß Anspruch 11, aufweisend mindestens eines der folgenden Merkmale:
wobei das Verfahren aufweist
iteratives Wiederholen, einmalig oder mehrere Male, der Sequenz des Entfernens von Material, des Messens eines Fortschritts davon, und des Analysierens, ob der gemessene Fortschritt den Anforderungen entspricht, bis das vordefinierte Materialentfernungsziel erreicht ist;
wobei die Komponententrägerstruktur (102) eines aus der Gruppe aufweist, bestehend aus einem Panel aufweisend mehrere verbundene Vorformen von Komponententrägern, einem Array aufweisend mehrere verbundene Vorformen von Komponententrägern, einer Vorform eines Komponententrägers, einem Coupon, und einem Komponententräger, insbesondere einem von einer gedruckten Leiterplatte und einem integrierten Schaltkreissubstrat;
wobei das Verfahren aufweist
Ausführen des Qualitätstests ohne menschliches Eingreifen.

13. Ein computerlesbares Medium, in welchem ein Computerprogramm zum Verarbeiten einer Komponententrägerstruktur (102) für einen Qualitätstest gespeichert ist, welches Computerprogramm, wenn es mittels eines oder einer Mehrzahl von Prozessoren (156) ausgeführt wird, eingerichtet ist, die Vorrichtung gemäß einem beliebigen der Ansprüche 1 bis 10 zu veranlassen, die Schritte eines Verfahrens gemäß einem beliebigen der Ansprüche 11 oder 12 auszuführen.

14. Ein Programmelement zum Verarbeiten einer Komponententrägerstruktur (102) für ein Qualitätstest, welches Programmelement, wenn es mittels eines oder einer Mehrzahl von Prozessoren (156) ausgeführt wird, eingerichtet ist, die Vorrichtung gemäß einem beliebigen der Ansprüche 1 bis 10 zu veranlassen, die Schritte eines Verfahrens gemäß einem beliebigen der Ansprüche 11 oder 12 auszuführen.

## Revendications

1. Appareil (100) pour traiter une structure de support de composant (102) pour un test de qualité, dans lequel l'appareil (100) comprend :
une unité de retrait de matériau (112) configurée pour retirer de la structure de support de composant (102) afin d'exposer au moins une cible de test (116) à l'intérieur de la structure de support de composant (102) à soumettre au test de qualité ;
une unité de mesure de progression (250) configurée pour mesurer une progression du retrait de matériau de la structure de support de composant (102) ;
une unité d'analyse (252) configurée pour analyser si le progrès mesuré répond à des exigences d'un objectif de retrait de matériau prédéfini ; et
une unité de commande (254) configurée pour commander, sur la base d'un résultat de l'analyse, si la séquence de retrait de matériau, de mesure de sa progression et d'analyse que la progression mesurée répond à des exigences de l'objectif de retrait de matériau prédéfini doit être répétée ou non,
**caractérisé en ce que** l'appareil (100) comprend en outre
une unité de détermination (114) configurée pour déterminer la au moins une cible de test (116) de la structure de support de composant (102) après ledit retrait de matériau ; et
une unité d'évaluation (118) configurée pour évaluer une caractéristique de la au moins une cible de test déterminée (116) de la structure de support de composant (102) afin d'évaluer la qualité de la structure de support de composant (102).

2. Appareil (100) selon la revendication 1, comprenant au moins l'une des caractéristiques suivantes :
dans lequel l'unité de commande (254) est configurée pour répéter de manière itérative une ou plusieurs fois la séquence de retrait de matériau, de mesure de sa progression et d'analyse que la progression mesurée répond aux exigences jusqu'à ce que l'objectif de retrait de matériau prédéfini soit atteint ;
dans lequel l'unité de commande (254) est configurée pour répéter de manière itérative la séquence dans une boucle de régulation.

3. Appareil (100) selon l'une quelconque des revendications 1 à 2, dans lequel l'unité de retrait de matériau (112) est configurée pour retirer du matériau de la structure de support de composant (102) par meulage.

4. Appareil (100) selon la revendication 3, comprenant au moins l'une des caractéristiques suivantes :
dans lequel l'unité de retrait de matériau (112) est configurée pour retirer du matériau de la structure de support de composant (102) par l'un du groupe constitué du meulage en section transversale et du meulage à plat ;
dans lequel l'unité de retrait de matériau (112) est configurée pour retirer du matériau de la structure de support de composant (102) par une étape de meulage grossier suivie d'une étape de meulage fin.

5. Appareil (100) selon l'une quelconque des revendications 1 à 4, comprenant au moins l'une des caractéristiques suivantes :
comprenant une unité de polissage (140) pour polir une surface exposée de la structure de support de composant (102) après avoir retiré du matériau ;
dans lequel l'unité de mesure de progression (250) est configurée pour mesurer la progression pendant le retrait de matériau par l'unité de retrait de matériau (112) ;
dans lequel l'unité de mesure de progression (250) est configurée pour mesurer la progression en détectant optiquement une image de la structure de support de composant (102).

6. Appareil (100) selon l'une quelconque des revendications 1 à 5, dans lequel l'unité de mesure de progression (250) est configurée pour mesurer la progression en mesurant électriquement un signal électrique au niveau d'une structure électroconductrice (116, 224) de la structure de support de composant (102).

7. Appareil (100) selon la revendication 6, comprenant au moins l'une des caractéristiques suivantes :
dans lequel la structure électroconductrice (116, 224) appartient à l'un du groupe constitué d'une cible de test (116) et d'une structure sacrificielle (224) de la structure de support de composant (102) ;
dans lequel l'unité de mesure de progression (250) est configurée pour mesurer la progression en détectant un signal électrique de la structure électroconductrice (116, 224) à retirer au moins partiellement pendant le retrait de matériau pour exposer la au moins une cible de test (116), dans lequel la structure électroconductrice (116, 224) est configurée pour être utilisée pour détecter une progression du retrait de matériau jusqu'à une exposition de la au moins une cible de test (116) conformément à l'objectif de retrait de matériau prédéfini.

8. Appareil (100) selon l'une quelconque des revendications 1 à 7, comprenant au moins l'une des caractéristiques suivantes :
dans lequel l'unité de mesure de progression (250) comprend une unité de quantification de matériau retiré (142) configurée pour quantifier une quantité de matériau retirée de la structure de support de composant (102) par l'unité de retrait de matériau (112) ;
dans lequel l'unité de mesure de progression (250) est configurée pour mesurer la progression sur la base d'une progression spatiale de l'unité de retrait de matériau (112) pendant un retrait de matériau de la structure de support de composant (102) ;
dans lequel l'unité de mesure de progression (250) est configurée pour mesurer la progression sur la base d'une détection d'une pression de contact de l'unité de retrait de matériau (112) contre la structure de support de composant (102) pendant un retrait de matériau de la structure de support de composant (102) ;
dans lequel l'unité de mesure de progression (250) est configurée pour mesurer la progression sur la base d'une détection d'une vitesse de rotation d'un corps rotatif de l'unité de retrait de matériau (112) pendant un retrait de matériau de la structure de support de composant (102).

9. Appareil (100) selon l'une quelconque des revendications 1 à 8,
comprenant une unité de mesure initiale (258) configurée pour mesurer la structure de support de composant (102) initialement avant le retrait de matériau ;
dans lequel l'unité de retrait de matériau (112) est configurée pour retirer du matériau de la structure de support de composant (102) sur la base d'un résultat de mesure de l'unité de mesure initiale (258).

10. Appareil (100) selon l'une quelconque des revendications 1 à 9, comprenant au moins l'une des caractéristiques suivantes :
dans lequel la au moins une cible de test (116) de la structure de support de composant (102) comprend au moins l'un du groupe constitué d'au moins un trou de perçage (158), et d'au moins une structure de couche (130, 132) ;
dans lequel une caractéristique de la au moins une cible de test (116) de la structure de support de composant (102) à évaluer pendant le test de qualité comprend au moins l'un du groupe constitué d'un diamètre (D) d'un trou de perçage (158), d'une distance (L) entre des trous de perçage adjacents (158), d'une largeur d'une trace électroconductrice d'une structure de couche électroconductrice (130), d'une distance entre des traces électroconductrices adjacentes d'une structure de couche électroconductrice (130), d'une épaisseur (d) d'une structure de couche (130, 132), d'une planéité d'une structure de couche (130, 132), d'une délamination d'une structure de couche (130, 132) et de toute caractéristique d'une structure de support de composant de type carte de circuit imprimé (102) ;
comprenant une unité de surveillance (260), en particulier un dispositif à rayons X, conçue pour surveiller, en particulier pour surveiller en continu, la structure de support de composant (102) au moins pendant au moins une partie de ladite séquence ;
dans lequel l'objectif de retrait de matériau est d'atteindre un centre (225) d'une cible de test (116), en particulier d'un trou de perçage ou d'une structure électroconductrice, de la structure de support de composant (102) ;
comprenant un bouchon mécanique (262) configuré pour venir en butée contre l'unité de retrait de matériau (112) afin de désactiver un retrait de matériau excessif de la structure de support de composant (102) par l'unité de retrait de matériau (112) ;
dans lequel l'appareil (100) est configuré pour effectuer le test de qualité sans intervention humaine ;
comprenant une unité d'alignement (154) configurée pour aligner la structure de support de composant (102) avant le retrait de matériau, en particulier sur la base d'une détection d'au moins une structure d'alignement (216) de la structure de support de composant (102).

11. Procédé de traitement d'une structure de support de composant (102), dans lequel le procédé comprend les étapes consistant à :
retirer du matériau de la structure de support de composant (102) pour exposer au moins une cible de test (116) à l'intérieur de la structure de support de composant (102) à soumettre au test de qualité ;
mesurer une progression du retrait de matériau de la structure de support de composant (102) ;
analyser si la progression mesurée répond à des exigences d'un objectif de retrait de matériau prédéfini ; et
commander, sur la base d'un résultat de l'analyse, si la séquence de retrait de matériau, de mesure de sa progression et d'analyse que la progression mesurée répond aux exigences de l'objectif de retrait de matériau prédéfini doit être répétée ou non,
**caractérisé en ce que** le procédé comprend en outre les étapes consistant à :
déterminer, par l'intermédiaire de l'unité de détermination (114), la au moins une cible de test (116) de la structure de support de composant (102) après ledit retrait de matériau ; et
évaluer, par l'intermédiaire d'une unité d'évaluation (118), une caractéristique de la au moins une cible de test déterminée (116) de la structure de support de composant (102) pour évaluer la qualité de la structure de support de composant (102).

12. Procédé (100) selon la revendication 11, comprenant au moins l'une des caractéristiques suivantes :
dans lequel le procédé comprend la répétition itérative une ou plusieurs fois de la séquence de retrait de matériau, de mesure de progression, et d'analyse que la progression mesurée répond aux exigences jusqu'à ce que l'objectif prédéfini de retrait de matériau soit atteint ;
dans lequel la structure de support de composant (102) comprend l'un du groupe constitué d'un panneau comprenant de multiples préformes connectées de supports de composant, d'un réseau comprenant de multiples préformes connectées de supports de composant, d'une préforme d'un support de composant, d'un coupon et d'un support de composant, en particulier l'un d'une carte de circuit imprimé et d'un substrat de circuit intégré ;
dans lequel le procédé comprend la réalisation du test de qualité sans intervention humaine.

13. Support lisible par ordinateur, dans lequel est stocké un programme informatique de traitement d'une structure de support de composant (102) pour un test de qualité, lequel programme informatique, lorsqu'il est exécuté par un ou plusieurs processeurs (156), est adapté pour amener l'appareil selon l'une quelconque des revendications 1 à 10 à exécuter les étapes d'un procédé selon l'une quelconque des revendications 11 ou 12.

14. Élément de programme de traitement d'une structure de support de composant (102) pour un test de qualité, lequel élément de programme, lorsqu'il est exécuté par un ou une pluralité de processeurs (156), est adapté pour amener l'appareil selon l'une quelconque des revendications 1 à 10 à exécuter les étapes d'un procédé selon l'une quelconque des revendications 11 ou 12.
